# EUROPEAN PATENT APPLICATION

(11) **EP 4 414 371 A1**
(43) Date of publication of application: **14.08.2024**
(21) Application number: 23807889.3
(22) Date of filing: 16.05.2023
(51) Int. Cl.: C07F 9/30, C09D 7/63, H10K 85/60, H10K 50/11, H10K 50/17, H10K 50/16

(54) **COMPOUND, COATING COMPOSITION COMPRISING SAME, ORGANIC LIGHT-EMITTING DEVICE COMPRISING SAME, AND METHOD FOR MANUFACTURING SAME**

(30) Priority: 16.05.2022 KR 20220059693
(71) Applicant: LG Chem, Ltd., Yeongdeungpo-gu Seoul 07336 (KR)
(72) Inventor: JUNG, Sejin, Daejeon 34122 (KR); KANG, Eunhye, Daejeon 34122 (KR); KIM, Shin Sung, Daejeon 34122 (KR); KIM, Ji Hoon, Daejeon 34122 (KR); SHIN, Jiyeon, Daejeon 34122 (KR); JEONG, Su Hun, Daejeon 34122 (KR); LEE, Jaechol, Daejeon 34122 (KR); LEE, Jiyoung, Daejeon 34122 (KR)
(74) Representative: Hoffmann Eitle
(86) International application number: PCT/KR2023/006645
(87) International publication number: WO 2023/224370

(57) **Abstract**

The present specification relates to a compound of Chemical Formula 1, a coating composition including the same, an organic light emitting device including the same, and a method for manufacturing the same.

## Description

### [Technical Field]

This application claims priority to and the benefit of Korean Patent Application No. 10-2022-0059693 filed in the Korean Intellectual Property Office on May 16, 2022, the entire contents of which are incorporated herein by reference.

The present specification relates to a compound, a coating composition including the same, an organic light emitting device including the same, and a method for manufacturing the same.

### [Background Art]

An organic light emission phenomenon is one of the examples of converting an electric current into visible rays through an internal process of a specific organic molecule. The principle of the organic light emission phenomenon is as follows. When an organic material layer is disposed between an anode and a cathode and an electric current is applied between the two electrodes, electrons and holes are injected into the organic material layer from the cathode and the anode, respectively. The electrons and the holes which are injected into the organic material layer are recombined to form an exciton, and the exciton falls down again to the ground state to emit light. An organic light emitting device using the principle may be generally composed of a cathode, an anode, and an organic material layer disposed therebetween, for example, a hole injection layer, a hole transport layer, a light emitting layer, an electron injection layer, and an electron transport layer.

In order to manufacture an organic light emitting device in the related art, a deposition process has been usually used. However, there are problems in that the loss of materials occurs frequently when an organic light emitting device is manufactured by a deposition process and in that it is difficult to manufacture a device having a large area, and to solve these problems, a device using a solution process has been developed.

Therefore, there is a need for the development of a material for a solution process.

### [Detailed Description of the Invention]

### [Technical Problem]

The present specification provides a compound, a coating composition including the same, an organic light emitting device including the same, and a method for manufacturing the same.

### [Technical Solution]

An exemplary embodiment of the present specification provides a compound of the following Chemical Formula 1.

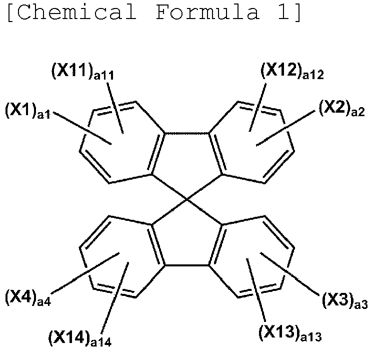

In Chemical Formula 1,
X1 to X4 are the same as or different from each other, and are each independently a group represented by the following Chemical Formula 2,
X11 to X14 are the same as or different from each other, and are each independently hydrogen; deuterium; a halogen group; a substituted or unsubstituted alkyl group; a substituted or unsubstituted cycloalkyl group; a substituted or unsubstituted aryl group; or a substituted or unsubstituted heteroaryl group, or are bonded to an adjacent group to form a substituted or unsubstituted ring,
a1 to a4 are each an integer of 0 or 1, and a1+a2+a3+a4 is an integer from 2 to 4,
a11 to a14 are each an integer from 0 to 4, and when a11 to a14 are each an integer of 2 or higher, substituents in the parenthesis are the same as or different from each other, 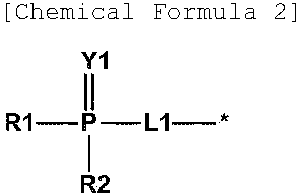 in Chemical Formula 2,
   Y1 is O, S or Se,
   L1 is a direct bond; a substituted or unsubstituted alkylene group; a substituted or unsubstituted arylene group; or a substituted or unsubstituted heteroarylene group,
   R1 and R2 are the same as or different from each other, and are each independently hydrogen; deuterium; a halogen group; a substituted or unsubstituted alkyl group; a substituted or unsubstituted cycloalkyl group; a substituted or unsubstituted aryl group; or a substituted or unsubstituted heteroaryl group, and
   at least one of X1 to X4 and X11 to X14 includes deuterium.

Another exemplary embodiment of the present specification provides a coating composition including the above-described compound.

Still another exemplary embodiment of the present specification provides an organic light emitting device including: a first electrode; a second electrode; and an organic material layer having one or more layers provided between the first electrode and the second electrode, in which one or more layers of the organic material layer include the above-described coating composition or a cured product thereof.

Yet another exemplary embodiment of the present specification provides a method for manufacturing an organic light emitting device, the method including: preparing a first electrode; forming an organic material layer having one or more layers on the first electrode; and forming a second electrode on the organic material layer, in which the forming of the organic material layer includes forming the organic material layer having one or more layers using the above-described coating composition.

Still yet another exemplary embodiment of the present specification provides a method for manufacturing an organic light emitting device, the method including: preparing a first electrode; forming an organic material layer having one or more layers on the first electrode; and forming a second electrode on the organic material layer, in which the forming of the organic material layer includes forming the organic material layer having one or more layers by depositing the above-described compound.

### [Advantageous Effects]

Since the compound according to an exemplary embodiment of the present specification has excellent solubility, there is an advantage in that various solvents can be selected when a coating composition is prepared.

In addition, the compound according to an exemplary embodiment of the present specification can be used as a material for an organic material layer of an organic light emitting device, and it is possible to obtain a device having low driving voltage, excellent efficiency characteristics, and/or excellent service life characteristics when the compound is applied to an organic light emitting device.

Further, the compound according to an exemplary embodiment of the present specification can be processed by a solution process, and thus enables a device to have a large area.

### [Brief Description of Drawings]

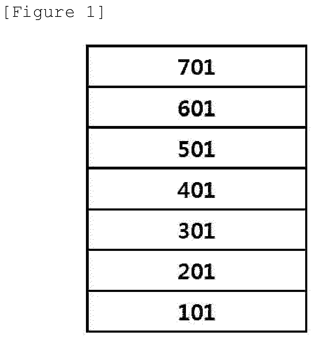

FIG. 1 is a view illustrating an example of an organic light emitting device according to an exemplary embodiment of the present invention.
101: Substrate
201: First electrode
301: Hole injection layer
401: Hole transport layer
501: Light emitting layer
601: Electron injection and transport layer
701: Second electrode

### [Best Mode]

Hereinafter, the present invention will be described in detail.

An exemplary embodiment of the present specification provides a compound of the following Chemical Formula 1.

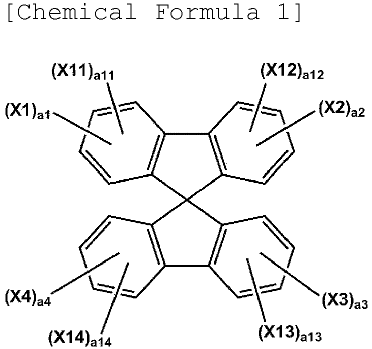

In Chemical Formula 1,
X1 to X4 are the same as or different from each other, and are each independently a group represented by the following Chemical Formula 2,
X11 to X14 are the same as or different from each other, and are each independently hydrogen; deuterium; a halogen group; a substituted or unsubstituted alkyl group; a substituted or unsubstituted cycloalkyl group; a substituted or unsubstituted aryl group; or a substituted or unsubstituted heteroaryl group, or are bonded to an adjacent group to form a substituted or unsubstituted ring,
a1 to a4 are each an integer of 0 or 1, and a1+a2+a3+a4 is an integer from 2 to 4,
a11 to a14 are each an integer from 0 to 4, and when a11 to a14 are each an integer of 2 or higher, substituents in the parenthesis are the same as or different from each other, 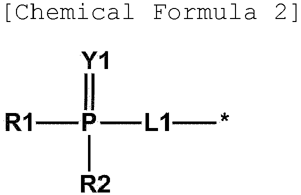 in Chemical Formula 2,
   Y1 is O, S or Se,
   L1 is a direct bond; a substituted or unsubstituted alkylene group; a substituted or unsubstituted arylene group; or a substituted or unsubstituted heteroarylene group,
   R1 and R2 are the same as or different from each other, and are each independently hydrogen; deuterium; a halogen group; a substituted or unsubstituted alkyl group; a substituted or unsubstituted cycloalkyl group; a substituted or unsubstituted aryl group; or a substituted or unsubstituted heteroaryl group, and
   at least one of X1 to X4 and X11 to X14 includes deuterium.

In an exemplary embodiment of the present specification, at least one of X1 to X4 and X11 to X14 includes deuterium. That is, the compound of Chemical Formula 1 includes one or more deuteriums.

When the compound includes deuterium, the bond energy of the C-D bond is greater than the bond energy of the C-H bond, so that the compound has strong intramolecular bond energy, and accordingly, material stability may be enhanced. Therefore, when the compound of Chemical Formula 1 is applied to an organic light emitting device, the compound exhibits an effect of improving efficiency and service life.

When one member is disposed "on" another member in the present specification, this includes not only a case where the one member is brought into contact with another member, but also a case where still another member is present between the two members.

When one part "includes" one constituent element in the present specification, unless otherwise specifically described, this does not mean that another constituent element is excluded, but means that another constituent element may be further included.

In the present specification, the term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more substituents are substituted, the two or more substituents may be the same as or different from each other.

In the present specification, the term "substituted or unsubstituted" means being substituted with one or two or more substituents selected from the group consisting of deuterium; a halogen group; an alkyl group; a cycloalkyl group; an alkoxy group; an aryloxy group; an amine group; an aryl group; and a heteroaryl group, being substituted with a substituent to which two or more substituents among the exemplified substituents are linked, or having no substituent. For example, "the substituent to which two or more substituents are linked" may be a biphenyl group. That is, the biphenyl group may also be an aryl group, and may be interpreted as a substituent to which two phenyl groups are linked.

In the present specification, ------ and * means a moiety bonded to another substituent or a bonding portion.

Examples of the substituents will be described below, but are not limited thereto.

In the present specification, examples of a halogen group include fluorine (F), chlorine (Cl), bromine (Br) or iodine (I).

In the present specification, an alkyl group may be straight-chained or branched, and the number of carbon atoms thereof is not particularly limited, but is preferably 1 to 60. According to an exemplary embodiment, the number of carbon atoms of the alkyl group is 1 to 30. Specific examples of the alkyl group include a methyl group, an ethyl group, a propyl group, an isopropyl group, a butyl group, an isobutyl group, a tert-butyl group, a pentyl group, a hexyl group, a heptyl group, an octyl group, and the like, but are not limited thereto.

In the present specification, an alkylene group means a group having two bonding positions in an alkyl group, that is, a divalent group. The above-described description on the alkyl group may be applied to the alkylene group, except for a divalent alkylene group.

In the present specification, the number of carbon atoms of the cycloalkyl group is not particularly limited, but is preferably 3 to 60. According to an exemplary embodiment, the number of carbon atoms of the cycloalkyl group is 3 to 30. Specific examples of the cycloalkyl group include a cyclopropyl group, a cyclobutyl group, a cyclopentyl group, a cyclohexyl group, a cycloheptyl group, a cyclooctyl group, and the like, but are not limited thereto.

In the present specification, an alkoxy group may be straight-chained, branched, or cyclic. The number of carbon atoms of the alkoxy group is not particularly limited, but is preferably 1 to 30. Specific examples of the alkoxy group include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, and the like, but are not limited thereto.

In the present specification, an amine group is a group represented by -NRaRb, and Ra and Rb are the same as or different from each other, and are each independently hydrogen; deuterium; a substituted or unsubstituted alkyl group; a substituted or unsubstituted aryl group; or a substituted or unsubstituted heteroaryl group. Specifically, the amine group may be selected from the group consisting of -NH₂; an alkylamine group; an arylalkylamine group; an arylamine group; an arylheteroarylamine group; an alkylheteroarylamine group; and a heteroarylamine group, and is not limited thereto. The number of carbon atoms of the amine group is not particularly limited, but is preferably 1 to 60.

In the present specification, an aryl group is not particularly limited, but may have preferably 6 to 60 carbon atoms, and may be a monocyclic aryl group or a polycyclic aryl group. According to an exemplary embodiment, the number of carbon atoms of the aryl group is 6 to 30. According to an exemplary embodiment, the number of carbon atoms of the aryl group is 6 to 20. Examples of a monocyclic aryl group as the aryl group include a phenyl group, a biphenyl group, a terphenyl group, and the like, but are not limited thereto. Examples of the polycyclic aryl group include a naphthyl group, an anthracenyl group, a phenanthrenyl group, a pyrenyl group, a perylenyl group, a triphenylenyl group, a chrysenyl group, a fluorenyl group, and the like, but are not limited thereto.

In the present specification, a fluorenyl group may be substituted, and two substituents may be bonded to each other to form a spiro structure.

When the fluorenyl group is substituted, the substituent may be 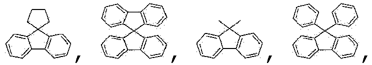 and the like, and the exemplified structure may be substituted with an additional substituent. However, the structure is not limited thereto.

In the present specification, an arylene group means a group having two bonding positions in an aryl group, that is, a divalent group. The above-described description on the aryl group may be applied to the arylene group, except for a divalent group.

In the present specification, a heteroaryl group is a heteroaryl group including one or more of N, O, P, S, Si, and Se as a heteroatom, and the number of carbon atoms thereof is not particularly limited, but may be 2 to 60. According to an exemplary embodiment, the number of carbon atoms of the heteroaryl group is 2 to 30. According to another exemplary embodiment, the number of carbon atoms of the heteroaryl group is 2 to 20. Examples of the heteroaryl group include a pyridyl group, a pyrrole group, a pyrimidyl group, a pyridazinyl group, a furanyl group, a thiophene group, a benzothiophene group, a benzofuran group, a dibenzothiophene group, a dibenzofuran group, and the like, but are not limited thereto.

In the present specification, a heteroarylene group means a group having two bonding positions in a heteroaryl group, that is, a divalent group. The above-described description on the heteroaryl group may be applied to the heteroarylene group, except for a divalent heteroarylene group.

In this specification, X# (#: an integer from 1 to 4) including deuterium means that X# is Chemical Formula 2 and at least one of R1, R2 and L1 in Chemical Formula 2 includes deuterium.

Hereinafter, the compound of Chemical Formula 1 will be described in detail.

In an exemplary embodiment of the present specification, a11 is an integer from 1 to 4.

In an exemplary embodiment of the present specification, a12 is an integer from 1 to 4.

In an exemplary embodiment of the present specification, a13 is an integer from 1 to 4.

In an exemplary embodiment of the present specification, a14 is an integer from 1 to 4.

In an exemplary embodiment of the present specification, a1+a11 is an integer from 1 to 4.

In an exemplary embodiment of the present specification, a2+a12 is an integer from 1 to 4.

In an exemplary embodiment of the present specification, a3+a13 is an integer from 1 to 4.

In an exemplary embodiment of the present specification, a4+a14 is an integer from 1 to 4.

In an exemplary embodiment of the present specification, a1 to a4 are each an integer of 0 or 1, and a1+a2+a3+a4 is an integer from 2 to 4.

In an exemplary embodiment of the present specification, a1 to a4 are each an integer of 0 or 1, and a1+a2+a3+a4 is 2.

In an exemplary embodiment of the present specification, a1 and a2 are 0, and a3 and a4 are 1.

In an exemplary embodiment of the present specification, a1 and a3 are 1, and a2 and a4 are 0.

In an exemplary embodiment of the present specification, Chemical Formula 1 is represented by the following Chemical Formula 1-1 or 1-2.

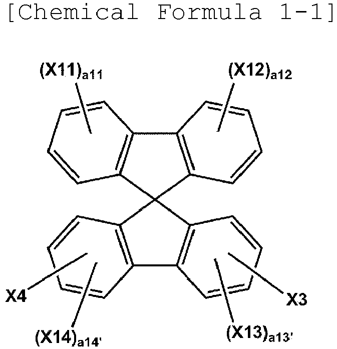

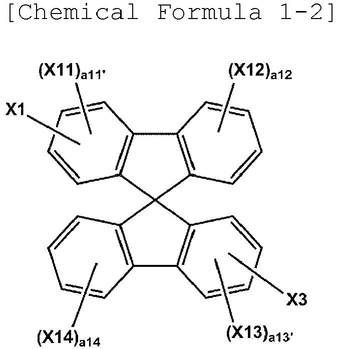

In Chemical Formulae 1-1 and 1-2,
X1, X3, X4, X11 to X14, a11, a12 and a14 are the same as those defined in Chemical Formula 1, and
all', a13' and a14' are each an integer from 1 to 3, and when all', a13' and a14' are each 2 or higher, substituents in the parenthesis are the same as or different from each other.

In an exemplary embodiment of the present specification, Chemical Formula 1 is represented by the following Chemical Formula 1-1-1 or 1-2-1.

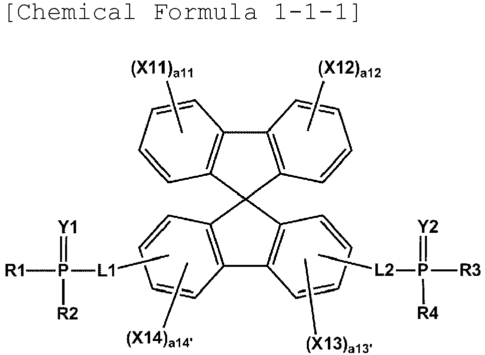

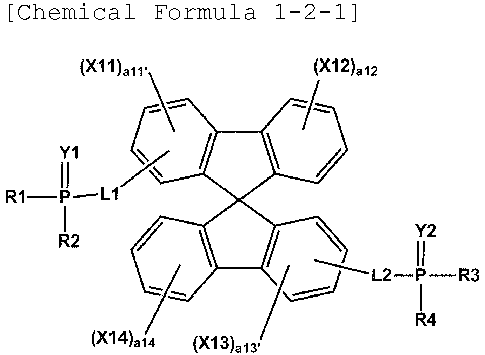

In Chemical Formulae 1-1-1 and 1-2-1,
X11 to X14, a11, a12 and a14 are the same as those defined in Chemical Formula 1,
Y1 and Y2 are the same as or different from each other, and are each independently O, S or Se,
L1 and L2 are the same as or different from each other, and are each independently a direct bond; a substituted or unsubstituted alkylene group; a substituted or unsubstituted arylene group; or a substituted or unsubstituted heteroarylene group,
R1 to R4 are the same as or different from each other, and are each independently hydrogen; deuterium; a halogen group; a substituted or unsubstituted alkyl group; a substituted or unsubstituted cycloalkyl group; or a substituted or unsubstituted aryl group; or a substituted or unsubstituted heteroaryl group, and
all', a13' and a14' are each an integer from 1 to 3, and when all', a13' and a14' are each 2 or higher, substituents in the parenthesis are the same as or different from each other.

In an exemplary embodiment of the present specification, R1 to R4 are the same as or different from each other, and are each independently a substituted or unsubstituted aryl group.

In an exemplary embodiment of the present specification, R1 to R4 are the same as or different from each other, and are each independently an aryl group which is unsubstituted or substituted with deuterium.

In an exemplary embodiment of the present specification, R1 to R4 are the same as or different from each other, and are each independently a substituted or unsubstituted phenyl group; a substituted or unsubstituted biphenyl group; a substituted or unsubstituted terphenyl group; a substituted or unsubstituted phenathrenyl group; a substituted or unsubstituted fluorenyl group; or a substituted or unsubstituted naphthyl group.

In an exemplary embodiment of the present specification, R1 to R4 are the same as or different from each other, and are each independently a phenyl group which is unsubstituted or substituted with deuterium; a biphenyl group which is unsubstituted or substituted with deuterium; a terphenyl group which is unsubstituted or substituted with deuterium; a phenanthrenyl group which is unsubstituted or substituted with deuterium; a fluorenyl group which is unsubstituted or substituted with deuterium; or a naphthyl group which is unsubstituted or substituted with deuterium.

In an exemplary embodiment of the present specification, X11 to X14 are the same as or different from each other, and are each independently hydrogen; deuterium; or a substituted or unsubstituted alkyl group, or are bonded to an adjacent substituent to form a substituted or unsubstituted ring.

In an exemplary embodiment of the present specification, X11 to X14 are the same as or different from each other, and are each independently hydrogen; deuterium; or an alkyl group which is unsubstituted or substituted with deuterium, or are bonded to an adjacent group to form a ring which is unsubstituted or substituted with deuterium.

In an exemplary embodiment of the present specification, when a12 is 2 or higher, Chemical Formula 1 can be represented by the following Chemical Formula 1-a.

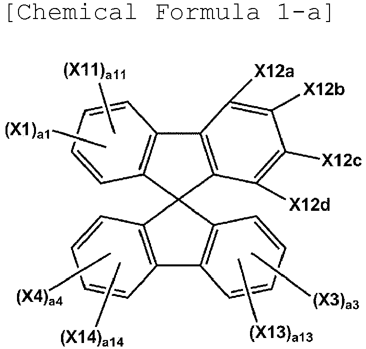

In Chemical Formula 1-a,
X1, X3, X4, X11, X13, X14, a1, a3, a4, a11, a13 and a14 are the same as those defined in Chemical Formula 1, and
X12a to X12d are the same as or different from each other, and are each independently hydrogen; deuterium; a halogen group; a substituted or unsubstituted alkyl group; a substituted or unsubstituted cycloalkyl group; a substituted or unsubstituted aryl group; a substituted or unsubstituted heteroaryl group; or a group (X2) represented by Chemical Formula 2, or are bonded to an adjacent group to form a substituted or unsubstituted ring.

In an exemplary embodiment of the present specification, a12 is 2 or higher, and adjacent X12's are bonded to each other to form a substituted or unsubstituted ring. Specifically, X12a and X12b are bonded to form a substituted or unsubstituted ring, X12b and X12c are bonded to form a substituted or unsubstituted ring and/or X12c and X12d are bonded to form a substituted or unsubstituted ring. In this case, Chemical Formula 1 may be each represented by the following Chemical Formulae 1-4 to 1-6.

In an exemplary embodiment of the present specification, Chemical Formula 1 is represented by any one of the following Chemical Formulae 1-4 to 1-6.

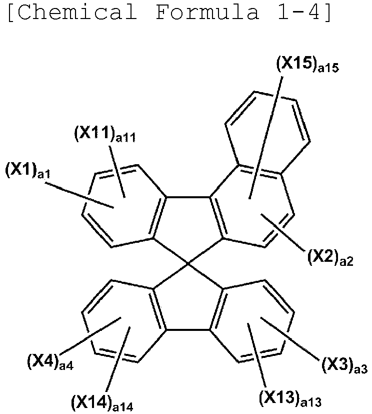

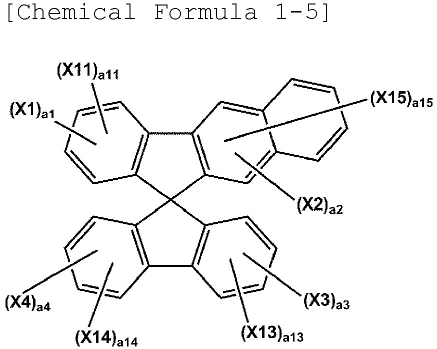

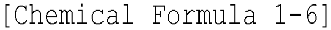

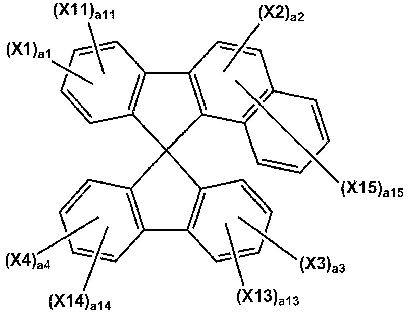

In Chemical Formulae 1-4 to 1-6,
X1 to X4, X11, X13, X14, a1 to a4, a11, a13 and a14 are the same as those defined in Chemical Formula 1,
X15 is hydrogen; deuterium; a halogen group; a substituted or unsubstituted alkyl group; a substituted or unsubstituted cycloalkyl group; a substituted or unsubstituted aryl group; or a substituted or unsubstituted heteroaryl group,
at least one of X1 to X4, X11 and X13 to X15 includes deuterium, and
a15 is an integer from 1 to 6, and when a15 is an integer of 2 or higher, structures in the parenthesis are the same as or different from each other.

In an exemplary embodiment of the present specification, a15+a2 is an integer of 6 or less.

In an exemplary embodiment of the present specification, a15+a2 is an integer from 1 to 6.

The example for the case where a12 is 2 or higher is equally applicable to the case where a11 is 2 or higher, the case where a13 is 2 or higher, and the case where a14 is 2 or higher.

In an exemplary embodiment of the present specification, a1 to a4 of Chemical Formulae 1-4 to 1-6 are each an integer of 0 or 1, and a1+a2+a3+a4 is an integer from 2 to 4.

In an exemplary embodiment of the present specification, a1 to a4 of Chemical Formulae 1-4 to 1-6 are each an integer of 0 or 1, and a1+a2+a3+a4 is 2.

In an exemplary embodiment of the present specification, a1 and a2 of Chemical Formulae 1-4 to 1-6 are 0, and a3 and a4 are 1.

In an exemplary embodiment of the present specification, a1 and a3 of Chemical Formulae 1-4 to 1-6 are 0, and a2 and a4 are 1.

In an exemplary embodiment of the present specification, a1 and a4 of Chemical Formulae 1-4 to 1-6 are 0, and a2 and a3 are 1.

In an exemplary embodiment of the present specification, a2 and a3 of Chemical Formulae 1-4 to 1-6 are 0, and a1 and a4 are 1.

In an exemplary embodiment of the present specification, a2 and a4 of Chemical Formulae 1-4 to 1-6 are 0, and a1 and a3 are 1.

In an exemplary embodiment of the present specification, a3 and a4 of Chemical Formulae 1-4 to 1-6 are 0, and a1 and a2 are 1.

In an exemplary embodiment of the present specification, X11, X13, X14 and X15 of Chemical Formulae 1-4 to 1-6 are the same as or different from each other, and are each independently hydrogen; deuterium; or a substituted or unsubstituted alkyl group.

In an exemplary embodiment of the present specification, X11, X13, X14 and X15 of Chemical Formulae 1-4 to 1-6 are the same as or different from each other, and are each independently hydrogen; deuterium; or an alkyl group which is unsubstituted or substituted with deuterium.

In the present specification, * of Chemical Formula 2 is a moiety which is bonded to Chemical Formula 1.

In an exemplary embodiment of the present specification, R1 and R2 are the same as or different from each other, and are each independently hydrogen; deuterium; or a substituted or unsubstituted aryl group.

In an exemplary embodiment of the present specification, R1 and R2 are the same as or different from each other, and are each independently a substituted or unsubstituted aryl group.

In an exemplary embodiment of the present specification, R1 and R2 are the same as or different from each other, and are each independently an aryl group which is unsubstituted or substituted with deuterium.

In an exemplary embodiment of the present specification, R1 and R2 are the same as or different from each other, and are each independently a substituted or unsubstituted phenyl group; a substituted or unsubstituted biphenyl group; a substituted or unsubstituted terphenyl group; a substituted or unsubstituted phenathrenyl group; a substituted or unsubstituted fluorenyl group; or a substituted or unsubstituted naphthyl group.

In an exemplary embodiment of the present specification, R1 and R2 are the same as or different from each other, and are each independently a phenyl group which is unsubstituted or substituted with deuterium; a biphenyl group which is unsubstituted or substituted with deuterium; a terphenyl group which is unsubstituted or substituted with deuterium; a phenanthrenyl group which is unsubstituted or substituted with deuterium; a fluorenyl group which is unsubstituted or substituted with deuterium; or a naphthyl group which is unsubstituted or substituted with deuterium.

In an exemplary embodiment of the present specification, L1 is a direct bond; or a substituted or unsubstituted arylene group having 6 to 30 carbon atoms.

In an exemplary embodiment of the present specification, L1 is a direct bond; or an arylene group having 6 to 30 carbon atoms, which is unsubstituted or substituted with deuterium.

In an exemplary embodiment of the present specification, L1 is a direct bond; or a substituted or unsubstituted phenylene group.

In an exemplary embodiment of the present specification, L1 is a direct bond; or a phenylene group which is unsubstituted or substituted with deuterium.

In an exemplary embodiment of the present specification, Y1 is O.

In an exemplary embodiment of the present specification, Y1 is S.

In an exemplary embodiment of the present specification, Y1 is Se.

In an exemplary embodiment of the present specification, one to eight of X1 to X4 and X11 to X14 include deuterium.

In an exemplary embodiment of the present specification, X1 includes deuterium.

In an exemplary embodiment of the present specification, at least one of R1 and R2 of X1 includes deuterium.

In an exemplary embodiment of the present specification, at least one of R1 and R2 of X1 is deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X1 include deuterium.

In an exemplary embodiment of the present specification, R1 and R2 of X1 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X1 are the same as or different from each other, and are each independently an aryl group substituted with deuterium.

In an exemplary embodiment of the present specification, L1 of X1 includes deuterium.

In an exemplary embodiment of the present specification, X2 includes deuterium.

In an exemplary embodiment of the present specification, at least one of R1 and R2 of X2 includes deuterium.

In an exemplary embodiment of the present specification, at least one of R1 and R2 of X2 is deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X2 include deuterium.

In an exemplary embodiment of the present specification, R1 and R2 of X2 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X2 are the same as or different from each other, and are each independently an aryl group substituted with deuterium.

In an exemplary embodiment of the present specification, L1 of X2 includes deuterium.

In an exemplary embodiment of the present specification, X3 includes deuterium.

In an exemplary embodiment of the present specification, at least one of R1 and R2 of X3 includes deuterium.

In an exemplary embodiment of the present specification, at least one of R1 and R2 of X3 is deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X3 include deuterium.

In an exemplary embodiment of the present specification, R1 and R2 of X3 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X3 are the same as or different from each other, and are each independently an aryl group substituted with deuterium.

In an exemplary embodiment of the present specification, L1 of X3 includes deuterium.

In an exemplary embodiment of the present specification, X4 includes deuterium.

In an exemplary embodiment of the present specification, at least one of R1 and R2 of X4 includes deuterium.

In an exemplary embodiment of the present specification, at least one of R1 and R2 of X4 is deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X4 include deuterium.

In an exemplary embodiment of the present specification, R1 and R2 of X4 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 and R2 of X4 are the same as or different from each other, and are each independently an aryl group substituted with deuterium.

In an exemplary embodiment of the present specification, L1 of X4 includes deuterium.

In an exemplary embodiment of the present specification, X11 includes deuterium.

In an exemplary embodiment of the present specification, X11 is deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or is bonded to an adjacent group to form a ring substituted with deuterium.

In an exemplary embodiment of the present specification, X11 is deuterium; or an alkyl group substituted with deuterium, or bonded to an adjacent group to form a ring substituted with deuterium.

In an exemplary embodiment of the present specification, X12 includes deuterium.

In an exemplary embodiment of the present specification, X12 is deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or is bonded to an adjacent group to form a ring substituted with deuterium.

In an exemplary embodiment of the present specification, X12 is deuterium; or an alkyl group substituted with deuterium, or bonded to an adjacent group to form a ring substituted with deuterium.

In an exemplary embodiment of the present specification, X13 includes deuterium.

In an exemplary embodiment of the present specification, X13 is deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or is bonded to an adjacent group to form a ring substituted with deuterium.

In an exemplary embodiment of the present specification, X13 is deuterium; or an alkyl group substituted with deuterium.

In an exemplary embodiment of the present specification, X14 includes deuterium.

In an exemplary embodiment of the present specification, X14 is deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or is bonded to an adjacent group to form a ring substituted with deuterium.

In an exemplary embodiment of the present specification, X14 is deuterium; or an alkyl group substituted with deuterium.

In an exemplary embodiment of the present specification, X1 and X3 include deuterium.

In an exemplary embodiment of the present specification, at least one of R1 and R2 of X1, and at least one of R1 and R2 of X3 include deuterium.

In an exemplary embodiment of the present specification, at least one of R1 and R2 of X1, and at least one of R1 and R2 of X3 are deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X1, R2 of X1, R1 of X3, and R2 of X3 each include deuterium.

In an exemplary embodiment of the present specification, R1 of X1, R2 of X1, R1 of X3, and R2 of X3 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X1, R2 of X1, R1 of X3, and R2 of X3 are the same as or different from each other, and are each independently an aryl group substituted with deuterium.

In an exemplary embodiment of the present specification, L1 of X1 and L1 of X3 include deuterium.

In an exemplary embodiment of the present specification, X1 and X4 include deuterium.

In an exemplary embodiment of the present specification, at least one of R1 and R2 of X1, and at least one of R1 and R2 of X4 include deuterium.

In an exemplary embodiment of the present specification, at least one of R1 and R2 of X1, and at least one of R1 and R2 of X4 are deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X1, R2 of X1, R1 of X4, and R2 of X4 each include deuterium.

In an exemplary embodiment of the present specification, R1 of X1, R2 of X1, R1 of X4, and R2 of X4 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X1, R2 of X1, R1 of X4, and R2 of X4 are the same as or different from each other, and are each independently an aryl group substituted with deuterium.

In an exemplary embodiment of the present specification, L1 of X1 and L1 of X4 include deuterium.

In an exemplary embodiment of the present specification, X2 and X3 include deuterium.

In an exemplary embodiment of the present specification, at least one of R1 and R2 of X2, and at least one of R1 and R2 of X3 include deuterium.

In an exemplary embodiment of the present specification, at least one of R1 and R2 of X2, and at least one of R1 and R2 of X3 are deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X2, R2 of X2, R1 of X3, and R2 of X3 each include deuterium.

In an exemplary embodiment of the present specification, R1 of X2, R2 of X2, R1 of X3, and R2 of X3 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X2, R2 of X2, R1 of X3, and R2 of X3 are the same as or different from each other, and are each independently an aryl group substituted with deuterium.

In an exemplary embodiment of the present specification, L1 of X2 and L1 of X3 include deuterium.

In an exemplary embodiment of the present specification, X2 and X4 include deuterium.

In an exemplary embodiment of the present specification, at least one of R1 and R2 of X2, and at least one of R1 and R2 of X4 include deuterium.

In an exemplary embodiment of the present specification, at least one of R1 and R2 of X2, and at least one of R1 and R2 of X4 are deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X2, R2 of X2, R1 of X4, and R2 of X4 each include deuterium.

In an exemplary embodiment of the present specification, R1 of X2, R2 of X2, R1 of X4, and R2 of X4 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X2, R2 of X2, R1 of X4, and R2 of X4 are the same as or different from each other, and are each independently an aryl group substituted with deuterium.

In an exemplary embodiment of the present specification, L1 of X2 and L1 of X4 include deuterium.

In an exemplary embodiment of the present specification, X3 and X4 include deuterium.

In an exemplary embodiment of the present specification, at least one of R1 and R2 of X3, and at least one of R1 and R2 of X4 include deuterium.

In an exemplary embodiment of the present specification, at least one of R1 and R2 of X3, and at least one of R1 and R2 of X4 are deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X3, R2 of X3, R1 of X4, and R2 of X4 each include deuterium.

In an exemplary embodiment of the present specification, R1 of X3, R2 of X3, R1 of X4, and R2 of X4 are the same as or different from each other, and are each independently deuterium; an alkyl group substituted with deuterium; a cycloalkyl group substituted with deuterium; an aryl group substituted with deuterium; or a heteroaryl group substituted with deuterium.

In an exemplary embodiment of the present specification, R1 of X3, R2 of X3, R1 of X4, and R2 of X4 are the same as or different from each other, and are each independently an aryl group substituted with deuterium.

In an exemplary embodiment of the present specification, L1 of X3 and L1 of X4 include deuterium.

In an exemplary embodiment of the present specification, two of X1 to X4 include deuterium, and X11 to X14 do not include deuterium.

In an exemplary embodiment of the present specification, two of X1 to X4 are a group represented by Chemical Formula 2, R1 and R2 of Chemical Formula 2 are an aryl group substituted with deuterium, and X11 to X14 are the same as or different from each other, and are each independently hydrogen; a halogen group; an alkyl group which is unsubstituted or substituted with a substituent other than deuterium; a cycloalkyl group which is unsubstituted or substituted with a substituent other than deuterium; an aryl group which is unsubstituted or substituted with a substituent other than deuterium; or a heteroaryl group which is unsubstituted or substituted with a substituent other than deuterium, or are bonded to an adjacent group to form a ring which is unsubstituted or substituted with a substituent other than deuterium.

In an exemplary embodiment of the present specification, two of X1 to X4 are a group represented by Chemical Formula 2, R1 and R2 of Chemical Formula 2 are an aryl group substituted with deuterium, and X11 to X14 are the same as or different from each other, and are each independently hydrogen; a halogen group; an alkyl group; a cycloalkyl group; an aryl group; or a heteroaryl group, or are bonded to an adjacent group to form a ring.

In an exemplary embodiment of the present specification, X11 and X12 include deuterium.

In an exemplary embodiment of the present specification, X11 and X12 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X11 and X12 are the same as or different from each other, and are each independently deuterium; or an alkyl group substituted with deuterium, or are bonded to an adjacent group to form a ring substituted with deuterium.

In an exemplary embodiment of the present specification, X11 and X13 include deuterium.

In an exemplary embodiment of the present specification, X11 and X13 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X11 and X13 are the same as or different from each other, and are each independently deuterium; or an alkyl group substituted with deuterium, or are bonded to an adjacent group to form a ring substituted with deuterium.

In an exemplary embodiment of the present specification, X11 and X14 include deuterium.

In an exemplary embodiment of the present specification, X11 and X14 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X11 and X14 are the same as or different from each other, and are each independently deuterium; or an alkyl group substituted with deuterium, or are bonded to an adjacent group to form a ring substituted with deuterium.

In an exemplary embodiment of the present specification, X12 and X13 include deuterium.

In an exemplary embodiment of the present specification, X12 and X13 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X12 and X13 are the same as or different from each other, and are each independently deuterium; or an alkyl group substituted with deuterium, or are bonded to an adjacent group to form a ring substituted with deuterium.

In an exemplary embodiment of the present specification, X12 and X14 include deuterium.

In an exemplary embodiment of the present specification, X12 and X14 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X12 and X14 are the same as or different from each other, and are each independently deuterium; or an alkyl group substituted with deuterium, or are bonded to an adjacent group to form a ring substituted with deuterium.

In an exemplary embodiment of the present specification, X13 and X14 include deuterium.

In an exemplary embodiment of the present specification, X13 and X14 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X13 and X14 are the same as or different from each other, and are each independently deuterium; or an alkyl group substituted with deuterium, or are bonded to an adjacent group to form a ring substituted with deuterium.

In an exemplary embodiment of the present specification, X11, X12 and X13 include deuterium.

In an exemplary embodiment of the present specification, X11, X12 and X13 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X11, X12 and X13 are the same as or different from each other, and are each independently deuterium; or an alkyl group substituted with deuterium, or are bonded to an adjacent group to form a ring substituted with deuterium.

In an exemplary embodiment of the present specification, X11, X12 and X14 include deuterium.

In an exemplary embodiment of the present specification, X11, X12 and X14 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X11, X12 and X14 are the same as or different from each other, and are each independently deuterium; or an alkyl group substituted with deuterium, or are bonded to an adjacent group to form a ring substituted with deuterium.

In an exemplary embodiment of the present specification, X12, X13 and X14 include deuterium.

In an exemplary embodiment of the present specification, X12, X13 and X14 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X12, X13 and X14 are the same as or different from each other, and are each independently deuterium; or an alkyl group substituted with deuterium, or are bonded to an adjacent group to form a ring substituted with deuterium.

In an exemplary embodiment of the present specification, X11 to X14 include deuterium.

In an exemplary embodiment of the present specification, X11 to X14 are the same as or different from each other, and are each independently deuterium; an alkyl group which is unsubstituted or substituted with deuterium; a cycloalkyl group which is unsubstituted or substituted with deuterium; an aryl group which is unsubstituted or substituted with deuterium; or a heteroaryl group which is unsubstituted or substituted with deuterium, or are bonded to an adjacent group to form a ring substituted with deuterium.

In an exemplary embodiment of the present specification, X11 to X14 are the same as or different from each other, and are each independently deuterium; or an alkyl group substituted with deuterium, or are bonded to an adjacent group to form a ring substituted with deuterium.

In an exemplary embodiment of the present specification, one or more of X11 to X14 include deuterium, and X1 to X4 do not include deuterium.

In an exemplary embodiment of the present specification, two of X1 to X4 and one or more of X11 to X14 include deuterium.

In an exemplary embodiment of the present specification, two of X1 to X4 and one of X11 to X14 include deuterium.

In an exemplary embodiment of the present specification, two of X1 to X4 and two of X11 to X14 include deuterium.

In an exemplary embodiment of the present specification, two of X1 to X4 and three of X11 to X14 include deuterium.

In an exemplary embodiment of the present specification, two of X1 to X4 and X11 to X14 include deuterium.

In an exemplary embodiment of the present specification, X1, X2 and X11 to X14 include deuterium.

In an exemplary embodiment of the present specification, X1, X3 and X11 to X14 include deuterium.

In an exemplary embodiment of the present specification, X1, X4 and X11 to X14 include deuterium.

In an exemplary embodiment of the present specification, X2, X3 and X11 to X14 include deuterium.

In an exemplary embodiment of the present specification, X2, X4 and X11 to X14 include deuterium.

In an exemplary embodiment of the present specification, X3, X4 and X11 to X14 include deuterium.

In an exemplary embodiment of the present specification, two of X1 to X4 are a group represented by Chemical Formula 2, R1 and R2 of Chemical Formula 2 are an unsubstituted aryl group, and X11 to X14 are the same as or different from each other, and are each independently deuterium; or an alkyl group substituted with deuterium, or are bonded to an adjacent group to form a ring substituted with deuterium.

In an exemplary embodiment of the present specification, two of X1 to X4 are a group represented by Chemical Formula 2, R1 and R2 of Chemical Formula 2 are an aryl group substituted with deuterium, and X11 to X14 are the same as or different from each other, and are each independently deuterium; an alkyl group substituted with deuterium, or are bonded to an adjacent group to form a ring substituted with deuterium.

In an exemplary embodiment of the present specification, the deuterium substitution rate of the compound is 20% or more. Specifically, the deuterium substitution rate of the compound is 25% or more, 30% or more, 35% or more, 40% or more, 45% or more, or 50% or more. The upper limit of the deuterium substitution rate is 100%.

In the present specification, the deuterium substitution ratio means the deuterium substitution ratio in the molecule, and the deuterium substitution distribution in the molecule can be grasped according to the following two methods. Of the following two methods, TLC-MS is a method for adjusting the deuterium substitution ratio during the synthesis process of a compound.

### 1. Use of TLC-MS (Thin-Layer Chromatography/Mass Spectrometry) (Synthesis process confirmation method)

The substitution rate may be calculated based on the maximum value (max. value) of the distribution of molecular weights at the end point of the reaction.

### 2. Quantitative analysis using NMR

Dimethylformamide (DMF) is added as an internal standard, and the deuterium substitution rate may be calculated from the integrated amount of the total peak using the integration ratio on 1H NMR.

In an exemplary embodiment of the present specification, the deuterium substitution rate of a phenyl group which is unsubstituted or substituted with deuterium; a biphenyl group which is unsubstituted or substituted with deuterium; a terphenyl group which is unsubstituted or substituted with deuterium; a phenanthrenyl group which is unsubstituted or substituted with deuterium; a fluorenyl group which is unsubstituted or substituted with deuterium; and a naphthyl group which is unsubstituted or substituted with deuterium is 20% to 100%. Specifically, the deuterium substitution rate is 40% to 100%, or 60% to 99%, and more specifically 70% to 99%.

As one example, the phenyl group substituted with deuterium may be represented by 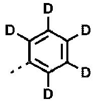 or 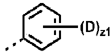 (z1: an integer from 1 to 5). In 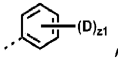 , when z1 is an integer from 2 to 5, the deuterium substitution rate of the structure is 40% to 100%.

In an exemplary embodiment of the present specification, when the fluorenyl group is additionally substituted with another substituent other than deuterium, the deuterium substitution rate of the portion except for the portion substituted with the other substituent in the fluorenyl group is 20% to 100%. For example, the fluorenyl group substituted with a methyl group and deuterium may be represented by the following structure, and in the following structure, the portion represented by deuterium may be replaced with hydrogen, and the deuterium substitution rate of the following structure is 20% to 100%. More specifically, the deuterium substitution rate of the following structure is 40% to 100%.

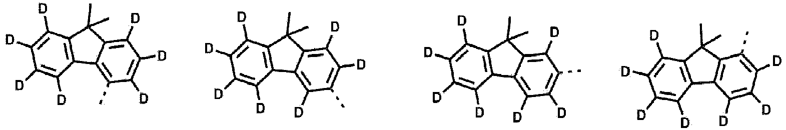

In an exemplary embodiment of the present specification, the deuterium substitution rate of a phenylene group substituted with deuterium; and a naphthylene group substituted with deuterium is 20% to 100%.

As one example, the phenylene group substituted with deuterium may be represented by 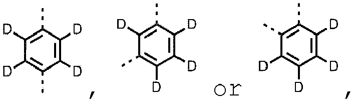 the portion represented by deuterium in the structure may be replaced with hydrogen, and the deuterium substitution rate of the structure is 20% to 100%. More specifically, the deuterium substitution rate of the structure is 40% to 100%.

As another example, the naphthylene group substituted with deuterium may be represented by any one of the following structures, and in the following structure, the portion represented by deuterium may be replaced with hydrogen, and the deuterium substitution rate of the structure is 20% to 100%. More specifically, the deuterium substitution rate of the following structure is 40% to 100%.

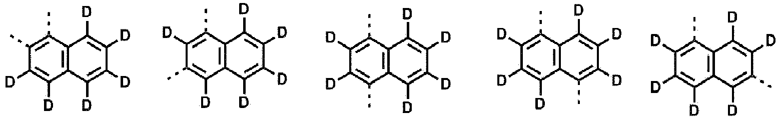

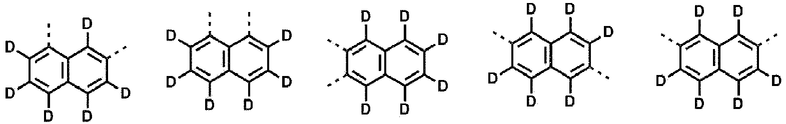

In an exemplary embodiment of the present specification, the compound of Chemical Formula 1 is any one of the following structures.

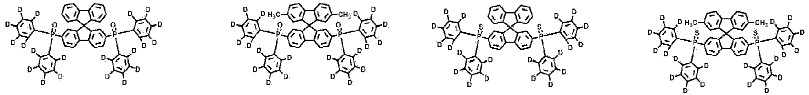

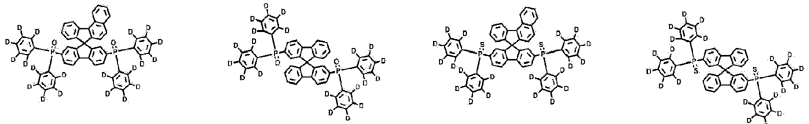

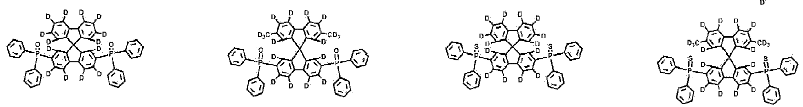

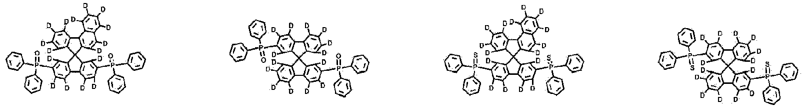

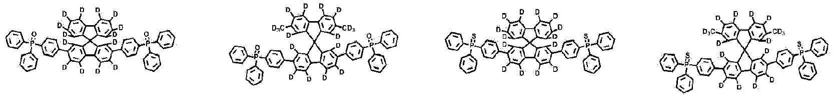

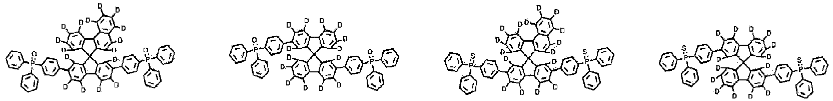

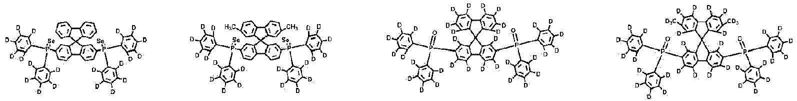

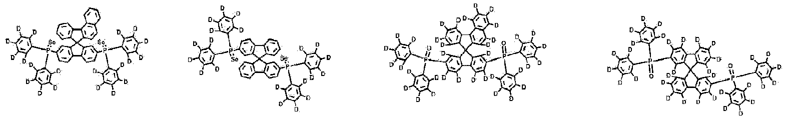

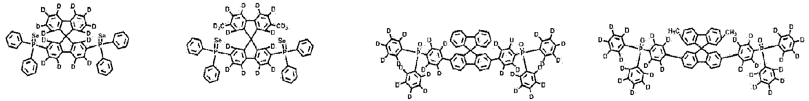

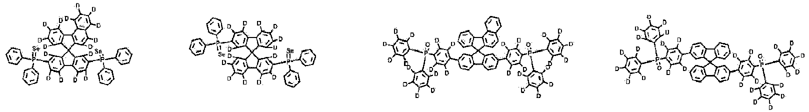

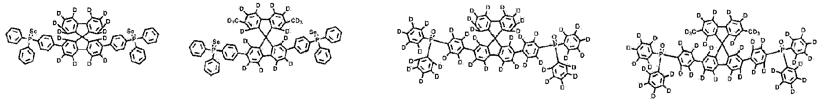

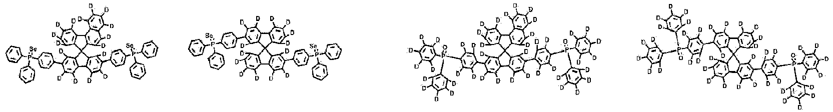

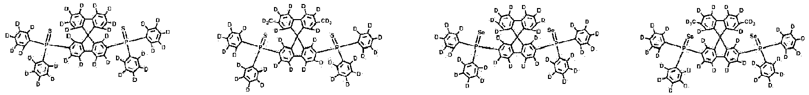

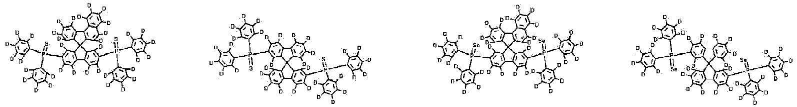

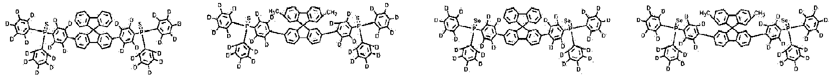

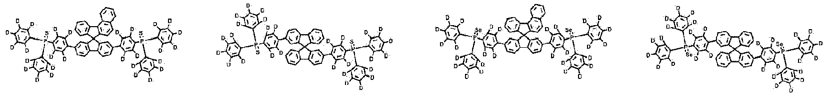

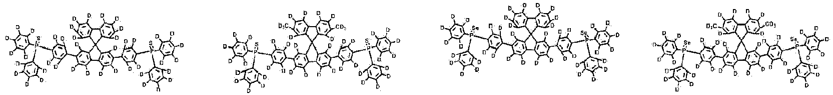

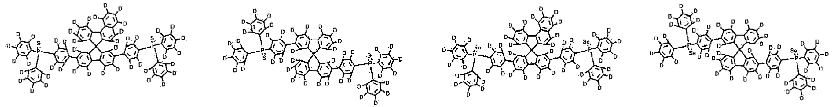

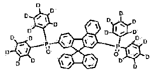

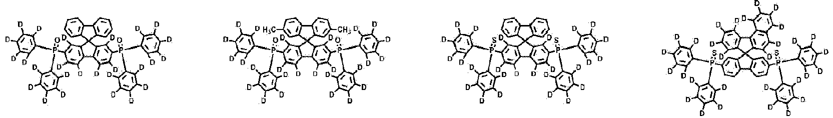

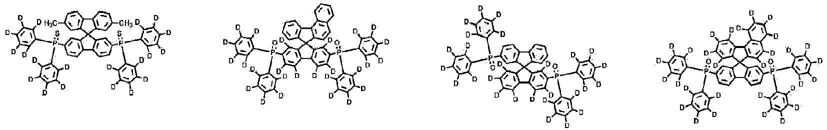

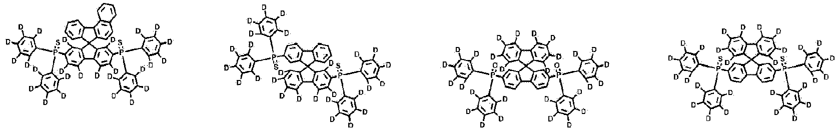

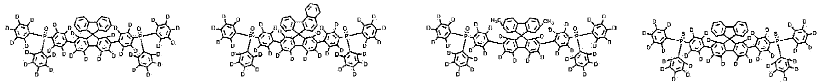

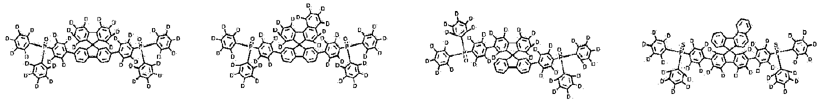

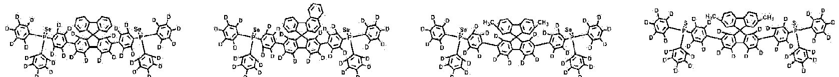

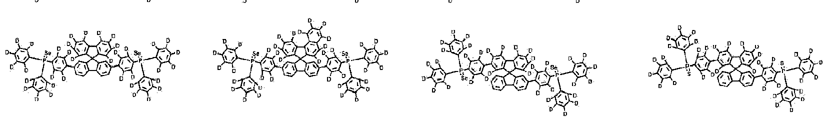

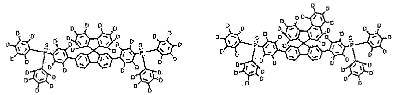

The compound of Chemical Formula 1 according to an exemplary embodiment of the present specification may be coupled by methods known in the art, such as the coupling reaction of two aryl groups having bromine and boronic acid functional groups, respectively in the presence of a palladium catalyst, and the type, position, or number of substituents may be changed according to the technology known in the art.

For example, for the compound of Chemical Formula 1, a core structure may be prepared by the following reaction scheme. The substituent may be bonded by a method known in the art, and the kind and position of the substituent or the number of substituents may be changed according to the technology known in the art.

### <Reaction Scheme>

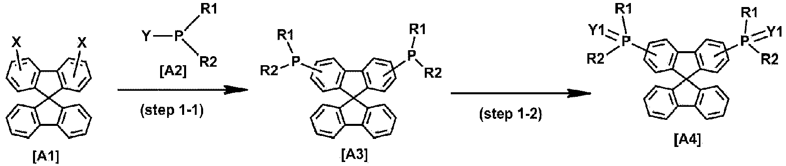

In the Reaction Scheme, Step 1-1 is a step of preparing an intermediate compound A3 having a phosphine group introduced therein by reacting compound A1 and compound A2, and Step 1-2 is a step of preparing a final compound A4 by oxidizing an intermediate compound A3.

In the Reaction Scheme X is Br, and each substituent is the same as the definition of the substituent of Chemical Formula 1.

In the Reaction Scheme, Y can be used without limitation as long as it is a material used in the art, and is, for example, Cl.

Hereinafter, a coating composition including the above-described compound will be described in detail.

An exemplary embodiment of the present specification provides a coating composition including the above-described compound of Chemical Formula 1.

In an exemplary embodiment of the present specification, the coating composition includes the compound of Chemical Formula 1 and a solvent.

In an exemplary embodiment of the present specification, the coating composition may be in a liquid phase.

In an exemplary embodiment of the present specification, the solvent is a solvent that dissolves the compound. Examples of the solvent include: a chlorine-based solvent such as chloroform, methylene chloride, 1,2-dichloroethane, 1,1,2-trichloroethane, chlorobenzene, and o-dichlorobenzene; an ether-based solvent such as tetrahydrofuran and dioxane; an aromatic hydrocarbon-based solvent such as toluene, xylene, trimethylbenzene, and mesitylene; a ketone-based solvent such as acetone, methyl ethyl ketone, and cyclohexanone; an ester-based solvent such as ethyl acetate, butyl acetate, and ethyl cellosolve acetate; a polyhydric alcohol such as ethylene glycol, ethylene glycol monobutyl ether, ethylene glycol monoethyl ether, ethylene glycol monomethyl ether, dimethoxy ethane, propylene glycol, diethoxymethane, triethylene glycol monoethyl ether, glycerin, and 1,2-hexanediol and a derivative thereof; an alcohol-based solvent such as methanol, ethanol, propanol, isopropanol, and cyclohexanol; a sulfoxide-based solvent such as dimethyl sulfoxide; an amide-based solvent such as N-methyl-2-pyrrolidone and N,N-dimethylformamide; a benzoate-based solvent such as methyl benzoate, butyl benzoate, and 3-phenoxybenzoate; and tetralin, and the like. The solvent can be any solvent that can dissolve or disperse the compound according to an exemplary embodiment of the present specification, and is not limited thereto.

In an exemplary embodiment of the present specification, the solvents may be used either alone or in a mixture of two or more solvents.

In an exemplary embodiment of the present specification, the coating composition may further include a dopant material. In this case, the dopant material may be a dopant material for an electron injection layer, a dopant material for an electron transport layer, or a dopant material for an electron injection and transport layer. The dopant material may include one or more selected from the group consisting of an organic-inorganic mixture, a metal, and an organic salt.

In an exemplary embodiment of the present specification, the dopant material may be an organic material including a substituent including CN and/or F.

In an exemplary embodiment of the present specification, the dopant material may include one or more selected from the group consisting of an alkali metal, an alkaline earth metal, a lanthanide metal, Se, Ru, and compounds thereof. Specifically, the alkali metal may be Li. Further, the alkaline earth metal may be Ca and Mg. In addition, the compound may be LiF, Liq, and RuCO₃. Furthermore, the lanthanide metal may be Yb.

In an exemplary embodiment of the present specification, the dopant material may include fullerene. Specifically, the fullerene may be a C60 fullerene or a C70 fullerene.

In an exemplary embodiment of the present specification, the dopant material may include a halide salt. Specifically, the halide salt may be LiF.

According to an exemplary embodiment of the present specification, the content of the dopant material may be 1 wt% or more and 50 wt% or less based on the total weight of the layer in which the dopant material is included.

In an exemplary embodiment of the present specification, the coating composition further includes: a single molecule including a photocurable group and/or a thermosetting group; or a single molecule including an end group capable of forming a polymer by heat. As described above, the single molecule including a photocurable group and/or a thermosetting group; or the single molecule including an end group capable of forming a polymer by heat may be a compound having a molecular weight of 3,000 g/mol or less, but the molecular weight is not limited to the exemplified molecular weight.

The single molecule including a photocurable group and/or a thermosetting group; or the single molecule including an end group capable of forming a polymer by heat may mean aryl such as phenyl, biphenyl, fluorene, and naphthalene; arylamine; or a single molecule in which a photocurable group, a thermosetting group and/or an end group capable of forming a polymer by heat are/is substituted with fluorene.

In an exemplary embodiment of the present invention, the coating composition has a viscosity of 2 cP to 15 cP at room temperature. When the above viscosity is satisfied, a device is easily manufactured. Specifically, a uniform film may be formed when an organic material layer in an organic light emitting device is formed.

An exemplary embodiment of the present specification provides an organic light emitting device including the compound of Chemical Formula 1, the coating composition, or a cured product thereof.

Hereinafter, an organic light emitting device will be described in detail.

An exemplary embodiment of the present specification provides an organic light emitting device formed using the compound of Chemical Formula 1.

An exemplary embodiment of the present specification provides an organic light emitting device including: a first electrode; a second electrode; and an organic material layer including one or more layers provided between the first electrode and the second electrode, in which one or more layers of the organic material layer include the above-described compound.

In an exemplary embodiment of the present specification, the organic material layer includes a light emitting layer. As an example, the light emitting layer includes the above-described compound. As a specific example, the light emitting layer includes the above-described compound as a host of the light emitting layer. As another specific example, the light emitting layer includes the above-described compound as a dopant of the light emitting layer.

In an exemplary embodiment of the present specification, the organic material layer includes one or more layers selected from the group consisting of an electron injection layer, an electron transport layer, and an electron injection and transport layer. As an example, one or more layers selected from the group consisting of an electron injection layer, an electron transport layer and an electron injection and transport layer include the above-described compound.

In an exemplary embodiment of the present specification, the organic material layer includes an electron transport layer. As an example, the electron transport layer includes the above-described compound.

In an exemplary embodiment of the present specification, the organic material layer includes one or more layers selected from the group consisting of an electron blocking layer, a hole blocking layer, a hole injection layer, a hole transport layer, and a hole injection and transport layer. As an example, one or more layers selected from the group consisting of the electron blocking layer, the hole blocking layer, the hole injection layer, the hole transport layer, and the hole injection and transport layer include the above-described compound.

In an exemplary embodiment of the present specification, the organic light emitting device includes an organic material layer having one layer (single layer), and the organic material layer includes the above-described compound.

In an exemplary embodiment of the present specification, the organic light emitting device includes an organic material layer having two or more layers (multilayers), and the organic material layer having two or more layers includes the above-described compound. For example, the organic material layer having any one layer of the organic material layer having two or more layers includes the above-described compound, and further includes the organic material layer having the other layer or more. The organic material layer having the other layer or more according to an exemplary embodiment does not include the above-described compound. The organic material layer having the other layer or more according to another exemplary embodiment includes the above-described compound. However, the organic material layer having the other layer or more according to another exemplary embodiment is not limited to the example.

The organic material layer having two or more layers includes two or more layers selected from the group consisting of, for example, a hole injection layer, a hole transport layer, a hole injection and transport layer, an electron blocking layer, a light emitting layer, a hole blocking layer, an electron transport layer, an electron injection layer, an electron injection and transport layer, and the like. In this case, the hole injection and transport layer means a layer which simultaneously injects and transports holes, and the electron injection and transport layer means a layer which simultaneously injects and transports electrons. However, the organic material layers forming the group are merely an example, and are not limited to the above example. Further, the organic material layer having two or more layers may include two or more layers that play the same role, if necessary. The organic light emitting device according to an exemplary embodiment includes a first electron transport layer and a second electron transport layer. However, the organic light emitting device is not limited to the example.

In an exemplary embodiment of the present specification, the organic material layer having two or more layers includes a light emitting layer and an organic material layer in addition to the light emitting layer. As an example, the light emitting layer is provided between the first electrode and the second electrode, and the organic material layer other than the light emitting layer is provided between the first electrode and the light emitting layer. As another example, the light emitting layer is provided between the first electrode and the second electrode, and the organic material layer other than the light emitting layer is provided between the light emitting layer and the second electrode. As still another example, the light emitting layer is provided between the first electrode and the second electrode, any one organic material layer other than the light emitting layer is provided between the first electrode and the light emitting layer, and any other organic material layer other than the light emitting layer is provided between the light emitting layer and the second electrode. However, the above structure is merely an example, and the structure is not limited to the above structure. Further, the organic material layer other than the light emitting layer may be one or more layers selected from the group consisting of, for example, a hole injection and transport layer, a hole injection layer, a hole transport layer, an electron blocking layer, a hole blocking layer, an electron transport layer, an electron injection layer, an electron injection and transport layer, and the like, but is not limited thereto.

In an exemplary embodiment of the present specification, the organic material layer includes a light emitting layer and a first organic material layer, and the first organic material layer includes the above-described compound.

In an exemplary embodiment of the present specification, the first organic material layer has a single layered (one layer) or multi-layered (two or more layers) structure. When the first organic material layer has two or more layers, the first organic material layers having two or more layers are the same as or different from each other.

In an exemplary embodiment of the present specification, the first organic material layer is provided between a light emitting layer and a cathode.

In an exemplary embodiment of the present specification, the second electrode is a cathode, and the first organic material layer is provided between the light emitting layer and the cathode.

In an exemplary embodiment of the present specification, the first organic material layer is at least one of an electron injection layer; an electron transport layer; and an electron injection and transport layer.

In an exemplary embodiment of the present specification, the organic material layer having a multi-layered structure included in the organic light emitting device includes: a light emitting layer; and a first organic material layer selected from the group consisting of a hole injection and transport layer, a hole injection layer, a hole transport layer, an electron blocking layer, a hole blocking layer, an electron transport layer, an electron injection layer, and an electron injection and transport layer, the light emitting layer is provided between a first electrode and a second electrode, and the first organic material layer is provided between the light emitting layer and the second electrode or between the first electrode and the light emitting layer. As an example, the first organic material layer includes the above-described compound.

According to a preferred exemplary embodiment of the present specification, the first organic material layer is at least one of an electron injection layer; an electron transport layer; and an electron injection and transport layer. More preferably, the first organic material layer is an electron transport layer.

In the above, the case where the organic material layer of the organic light emitting device includes the above-described compound is exemplified. In an exemplary embodiment of the present specification, the organic material layer including the above-described compound may include a coating composition including the above-described compound or a cured product thereof instead of the above-described compound.

As an example, an exemplary embodiment of the present specification provides an organic light emitting device including: a first electrode; a second electrode; and an organic material layer having one or more layers provided between the first electrode and the second electrode, in which one or more layers of the organic material layer include the above-described coating composition or a cured product thereof. As another example, the above-described organic material layer includes a light emitting layer and a first organic material layer, and the first organic material layer includes the coating composition or a cured product thereof.

In an exemplary embodiment of the present specification, the cured product is in a state in which the coating composition is cured by a heat treatment or a light treatment.

The structure of the organic light emitting device according to an exemplary embodiment of the present specification is illustrated in FIG. 1. FIG. 1 exemplifies a structure of an organic light emitting device in which a first electrode 201, a hole injection layer 301, a hole transport layer 401, a light emitting layer 501, an electron injection and transport layer 601, and a second electrode 701 are sequentially stacked on a substrate 101. However, FIG. 1 exemplifies an organic light emitting device according to an exemplary embodiment of the present specification, and the structure of the organic light emitting device of the present specification is not limited thereto.

In an exemplary embodiment of the present specification, the first electrode is an anode, and the second electrode is a cathode.

In another exemplary embodiment of the present specification, the first electrode is a cathode, and the second electrode is an anode.

In general, a hole injection layer, a hole transport layer or an electron blocking layer in an organic light emitting device is provided between an anode and a light emitting layer. As a specific example, the hole injection layer is provided on the anode, the hole transport layer is provided on the hole injection layer, and the electron blocking layer is provided on the hole transport layer, but the present invention is not limited to the above examples.

Further, in general, an electron injection layer, an electron transport layer or a hole blocking layer in an organic light emitting device is provided between a cathode and a light emitting layer. As a specific example, the hole blocking layer is provided on the light emitting layer, the electron transport layer is provided on the hole blocking layer, and the electron injection layer is provided on the electron transport layer, but the present invention is not limited to the above examples.

As described above, an organic light emitting device having an organic material layer having a single-layered or multi-layered structure may have, for example, the following stacking structure, but the stacking structure is not limited thereto.
(1) Anode/Hole transport layer/Light emitting layer/Cathode
(2) Anode/Hole injection layer/Hole transport layer/Light emitting layer/Cathode
(3) Anode/Hole injection layer/Hole buffer layer/Hole transport layer/Light emitting layer/Cathode
(4) Anode/Hole transport layer/Light emitting layer/Electron transport layer/Cathode
(5) Anode/Hole transport layer/Light emitting layer/Electron transport layer/Electron injection layer/Cathode
(6) Anode/Hole injection layer/Hole transport layer/Light emitting layer/Electron transport layer/Cathode
(7) Anode/Hole injection layer/Hole transport layer/Light emitting layer/Electron transport layer/Electron injection layer/Cathode
(8) Anode/Hole injection layer/Hole buffer layer/Hole transport layer/Light emitting layer/Electron transport layer/Cathode
(9) Anode/Hole injection layer/Hole buffer layer/Hole transport layer/Light emitting layer/Electron transport layer/Electron injection layer/Cathode
(10) Anode/Hole transport layer/Electron blocking layer/Light emitting layer/Electron transport layer/Cathode
(11) Anode/Hole transport layer/Electron blocking layer/Light emitting layer/Electron transport layer/Electron injection layer/Cathode
(12) Anode/Hole injection layer/Hole transport layer/Electron blocking layer/Light emitting layer/Electron transport layer/Cathode
(13) Anode/Hole injection layer/Hole transport layer/Electron blocking layer/Light emitting layer/Electron transport layer/Electron injection layer/Cathode
(14) Anode/Hole transport layer/Light emitting layer/Hole blocking layer/Electron transport layer/Cathode
(15) Anode/Hole transport layer/Light emitting layer/Hole blocking layer/Electron transport layer/Electron injection layer/Cathode
(16) Anode/Hole injection layer/Hole transport layer/Light emitting layer/Hole blocking layer/Electron transport layer/Cathode
(17) Anode/Hole injection layer/Hole transport layer/Light emitting layer/Hole blocking layer/Electron transport layer/Electron injection layer/Cathode
(18) Anode/Hole injection layer/Hole transport layer/Light emitting layer/Hole blocking layer/Electron transport layer/Electron injection layer/Cathode/Capsule
(19) Anode/Hole injection layer/First hole transport layer/Second hole transport layer/Light emitting layer/Hole blocking layer/Electron transport layer/Electron injection layer/Cathode/Capsule

In the structures, the "Electron transport layer/Electron injection layer" may be replaced with an "electron injection and transport layer" or a "layer that simultaneously transports and injects electrons".

Further, in the structures, the "Hole injection layer/Hole transport layer" may be replaced with the "hole injection and transport layer" or the "layer which simultaneously injects and transports holes".

In an exemplary embodiment of the present specification, the organic light emitting device may be a normal type organic light emitting device in which an anode, an organic material layer having one or more layers, and a cathode are sequentially stacked on a substrate.

In another exemplary embodiment of the present invention, the organic light emitting device may be an inverted type organic light emitting device in which a cathode, an organic material layer having one or more layers, and an anode are sequentially stacked on a substrate.

An exemplary embodiment of the present specification provides a method for manufacturing an organic light emitting device formed using the above-described compound or the above-described coating composition.

The organic light emitting device according to an exemplary embodiment of the present specification may be manufactured by the materials and methods known in the art, except that one or more layers of the organic material layer are formed using the above-described compound or the above-described coating composition.

For example, the organic light emitting device of the present invention may be manufactured by sequentially stacking an anode, an organic material layer, and a cathode on a substrate. In this case, the organic light emitting device may be manufactured by depositing a metal or a metal oxide having conductivity, or an alloy thereof on a substrate to form an anode, forming an organic material layer including one or more layers of a hole injection layer, a hole transport layer, a light emitting layer, an electron injection layer, an electron transport layer, a hole transport and injection layer, and an electron injection and transport layer thereon through a solution process, a deposition process, the like, and then depositing a material, which may be used as a cathode, thereon, by using a physical vapor deposition (PVD) method such as sputtering or e-beam evaporation. In addition to such a method, the organic light emitting device may also be manufactured by consecutively depositing a cathode material, an organic material layer and an anode material on a substrate.

Specifically, an exemplary embodiment of the present specification includes: preparing a first electrode; forming an organic material layer on the first electrode; and forming a second electrode on the organic material layer, in which the forming of the organic material layer includes forming an organic material layer having one or more layers using the coating composition.

In an exemplary embodiment of the present invention, the forming of the organic material layer having one or more layers using the coating composition uses a spin coating method.

In another exemplary embodiment of the present invention, the forming of the organic material layer having one or more layers using the coating composition uses a printing method.

In an exemplary embodiment of the present invention, examples of the printing method include coating jet printing, nozzle printing, offset printing, transfer printing, screen printing, or the like, but are not limited to the printing methods listed above.

A solution process is suitable for the coating composition according to an exemplary embodiment of the present invention due to the structural characteristics thereof, so that the organic material layer may be formed by a printing method, and as a result, there is an economic effect in terms of time and costs when a device is manufactured.

In an exemplary embodiment of the present invention, the forming of the organic material layer using the coating composition includes: coating the coating composition; and drying, heat-treating and/or light-treating the coated coating composition.

In an exemplary embodiment of the present specification, the forming of the organic material layer having one or more layers using the coating composition includes: coating the coating composition on the first electrode; and heat-treating or light-treating the coated coating composition. Preferably, the forming of the organic material layer having one or more layers using the coating composition includes: coating the first electrode or another organic material layer with the coating composition; and heat-treating the coated coating composition.

In an exemplary embodiment of the present specification, the heat-treating of the coated coating composition includes drying the coated coating composition.

In an exemplary embodiment of the present specification, another organic material layer means an organic material layer previously formed before forming the organic material layer using the coating composition. In this case, another organic material layer may be an organic material layer previously formed using the above-described coating composition, and may be an organic material layer previously formed using another material without using the above-described coating composition.

In an exemplary embodiment of the present invention, the heat-treating of the coating composition may be performed through a heat treatment, and the heat treatment temperature in the heat-treating of the coating composition may be 85°C to 250°C, may be 100°C to 250°C according to an exemplary embodiment, and may be 150°C to 250°C in another exemplary embodiment.

In an exemplary embodiment of the present invention, the heat treatment time in the heat treatment step is 1 minute to 2 hours, may be 1 minute to 1 hour according to an exemplary embodiment, and may be 10 minutes to 1 hour in another exemplary embodiment. As a preferred example, the heat treatment time in the heat treatment step is 20 minutes to 40 minutes.

When the coating composition in the forming of the organic material layer having one or more layers using the coating composition further includes: a single molecule including a photocurable group and/or a thermosetting group; or a single molecule including an end group capable of forming a polymer by heat, an organic material layer including a thin-filmed structure may be provided by forming cross-linkages between components included in the coating composition through the heat-treatment or light-treatment step. In this case, it is possible to prevent the organic material layer from being dissolved, morphologically affected or decomposed by a solvent when another layer is stacked on the surface of the organic material layer formed using the coating composition. Therefore, when the organic material layer is formed by the manufacturing method, resistance to a solvent is increased, so that a plurality of layers may be formed by repeatedly carrying out solution deposition and cross-linking methods, and stability is increased, so that the service life characteristics of the device may be increased.

In another exemplary embodiment of the present invention, the forming of the organic material layer having one or more layers using the coating composition uses deposition.

An exemplary embodiment of the present specification provides a method for manufacturing an organic light emitting device, the method including: preparing a first electrode; forming an organic material layer having one or more layers on the first electrode; and forming a second electrode on the organic material layer, in which the forming of the organic material layer includes forming the organic material layer having one or more layers by depositing the compound.

In an exemplary embodiment of the present specification, the depositing of the compound may be performed under vacuum conditions. Specifically, the depositing of the compound may be performed at a degree of vacuum of 5×10⁻⁸ torr to 2×10⁻⁷ torr.

In an exemplary embodiment of the present specification, the depositing of the compound may be performed at a rate of 0.01 Å/sec to 10 Å/sec. Specifically, the depositing of the compound may be performed at a rate of 0.05 Å/sec to 8 Å/sec, or 0.1 Å/sec to 6 Å/sec.

Hereinafter, a material included in the organic light emitting device will be described.

As the anode material, materials having a high work function are usually preferred so as to facilitate the injection of holes into an organic material layer. Examples thereof include: a metal, such as vanadium, chromium, copper, zinc, and gold, or an alloy thereof; a metal oxide, such as zinc oxide, indium oxide, indium tin oxide (ITO), and indium zinc oxide (IZO); a combination of a metal and an oxide, such as ZnO:Al or SnO₂:Sb; a conductive polymer, such as poly(3-methylthiophene), poly[3,4-(ethylene-1,2-dioxy)thiophene] (PEDOT), polypyrrole, and polyaniline; and the like, but are not limited thereto.

As the cathode material, materials having a low work function are usually preferred so as to facilitate the injection of electrons into an organic material layer. Examples thereof include: a metal, such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

The light emitting layer may include a host material for a light emitting layer and/or a dopant material for a light emitting layer.

Examples of the host material for a light emitting layer include a fused aromatic ring derivative, a hetero ring-containing compound, or the like. Specific examples of the fused aromatic ring derivative include anthracene derivatives, pyrene derivatives, naphthalene derivatives, pentacene derivatives, phenanthrene compounds, fluoranthene compounds, and the like, and specific examples of the hetero ring-containing compound include dibenzofuran derivatives, ladder-type furan compounds, pyrimidine derivatives, and the like, but the examples are not limited thereto. Specifically, the host material for a light emitting layer is an anthracene derivative.

In an exemplary embodiment of the present invention, as the host material, a mixture of two or more host materials selected from the above-described host materials may be used. As an example, an anthracene derivative and a pyrene derivative may be used by being mixed at a weight ratio of 1:99 to 99:1. As a more specific example, an anthracene derivative and a pyrene derivative may be used by being mixed at a weight ratio of 92:8.

In an exemplary embodiment of the present specification, the host of the light emitting layer includes a compound of the following EH-1.

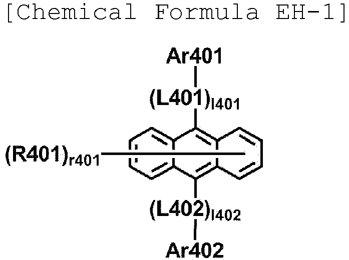

In Chemical Formula EH-1,
L401 and L402 are the same as or different from each other, and are each independently a direct bond; a substituted or unsubstituted arylene group; or a substituted or unsubstituted heteroarylene group,
Ar401 and Ar402 are the same as or different from each other, and are each independently hydrogen; deuterium; a substituted or unsubstituted aryl group; or a substituted or unsubstituted heteroaryl group,
R401 is hydrogen; deuterium; a halogen group; a substituted or unsubstituted alkyl group; a substituted or unsubstituted cycloalkyl group; a substituted or unsubstituted aryl group; or a substituted or unsubstituted heteroaryl group,
1401 and l402 are the same as or different from each other, and are each independently an integer from 1 to 10, and when l401 and l402 are each 2 or higher, structures in the parenthesis are the same as or different from each other, and
r401 is an integer from 1 to 8, and when r401 is 2 or higher, two or more R401's are the same as or different from each other.

In an exemplary embodiment of the present specification, L401 and L402 are the same as or different from each other, and are each independently a direct bond; or a substituted or unsubstituted arylene group.

In an exemplary embodiment of the present specification, L401 and L402 are the same as or different from each other, and are each independently a direct bond; a substituted or unsubstituted phenylene group; a substituted or unsubstituted biphenylene group; a substituted or unsubstituted terphenylene group; a substituted or unsubstituted naphthylene group; or a substituted or unsubstituted anthrylene group.

In an exemplary embodiment of the present specification, Chemical Formula EH-1 is represented by the following Chemical Formula EH-2.

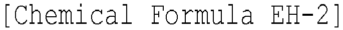

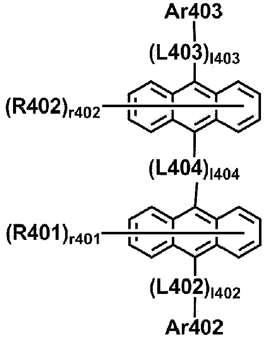

In Chemical Formula EH-2,
L402 to L404 are the same as or different from each other, and are each independently a direct bond; a substituted or unsubstituted arylene group; or a substituted or unsubstituted heteroarylene group,
Ar402 and Ar403 are the same as or different from each other, and are each independently hydrogen; deuterium; a substituted or unsubstituted aryl group; or a substituted or unsubstituted heteroaryl group,
R401 and R402 are the same as or different from each other, and are each independently hydrogen; deuterium; a halogen group; a substituted or unsubstituted alkyl group; a substituted or unsubstituted cycloalkyl group; a substituted or unsubstituted aryl group; or a substituted or unsubstituted heteroaryl group,
l402 to l404 are the same as or different from each other, and are each independently an integer from 1 to 3, and when l402 to l404 are each 2 or higher, structures in the parenthesis are the same as or different from each other, and
r401 and r402 are each an integer from 1 to 8, and when r401 and r402 are each 2 or higher, substituents in the parenthesis are the same as or different from each other.

In an exemplary embodiment of the present specification, L402 to L404 are the same as or different from each other, and are each independently a direct bond; or a substituted or unsubstituted arylene group.

In an exemplary embodiment of the present specification, L404 is a substituted or unsubstituted arylene group.

In an exemplary embodiment of the present specification, L404 is a substituted or unsubstituted phenylene group; a substituted or unsubstituted biphenylene group; or a substituted or unsubstituted naphthylene group.

In an exemplary embodiment of the present specification, L404 is a phenylene group; a biphenylene group; or a naphthylene group.

In an exemplary embodiment of the present specification, l404 is 3.

In an exemplary embodiment of the present specification, L402 and L403 are each a direct bond.

In an exemplary embodiment of the present specification, Ar401 and Ar402 are the same as or different from each other, and are each independently a substituted or unsubstituted aryl group.

In an exemplary embodiment of the present specification, Ar401 and Ar402 are the same as or different from each other, and are each independently a substituted or unsubstituted phenyl group; a substituted or unsubstituted biphenyl group; a substituted or unsubstituted terphenyl group; or a substituted or unsubstituted naphthyl group.

In an exemplary embodiment of the present specification, Ar401 and Ar402 are each a substituted or unsubstituted naphthyl group.

In an exemplary embodiment of the present specification, Ar401 and Ar402 are each a naphthyl group.

In an exemplary embodiment of the present specification, Ar403 is a substituted or unsubstituted aryl group.

In an exemplary embodiment of the present specification, Ar403 is a substituted or unsubstituted phenyl group; a substituted or unsubstituted biphenyl group; a substituted or unsubstituted terphenyl group; or a substituted or unsubstituted naphthyl group.

In an exemplary embodiment of the present specification, Ar403 is a substituted or unsubstituted naphthyl group.

In an exemplary embodiment of the present specification, Ar403 is a naphthyl group.

In an exemplary embodiment of the present specification, R401 and R402 are the same as or different from each other, and are each independently hydrogen; or deuterium.

In an exemplary embodiment of the present specification, Chemical Formula EH-1 is the following structure.

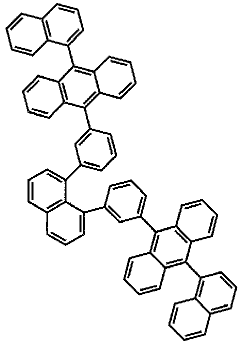

Examples of the dopant material for a light emitting layer include aromatic amine derivatives, styrylamine compounds, boron complexes, fluoranthene compounds, metal complexes, and the like. Specifically, the aromatic amine derivative is a fused aromatic ring derivative having a substituted or unsubstituted arylamine group, and examples thereof include pyrene, anthracene, chrysene, periflanthene, and the like having an arylamine group. Further, the styrylamine compound is a compound in which a substituted or unsubstituted arylamine is substituted with at least one arylvinyl group, and one or two or more substituents selected from the group consisting of an aryl group, a silyl group, an alkyl group, a cycloalkyl group, and an arylamine group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto. Specifically, the dopant for a light emitting layer is a pyrene-based compound having a substituted or unsubstituted arylamine group.

In an exemplary embodiment of the present specification, the dopant of the light emitting layer includes a compound of the following Chemical Formula ED-1.

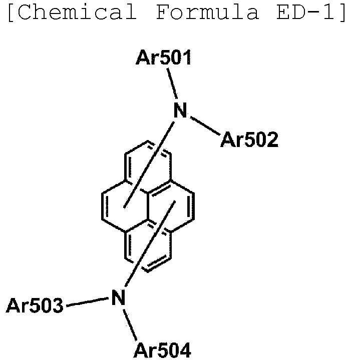

In Chemical Formula ED-1,
Ar501 to Ar504 are the same as or different from each other, and are each independently hydrogen; deuterium; a substituted or unsubstituted alkyl group; a substituted or unsubstituted aryl group; or a substituted or unsubstituted heteroaryl group.

In an exemplary embodiment of the present specification, Chemical Formula ED-1 is the following Chemical Formula ED-2.

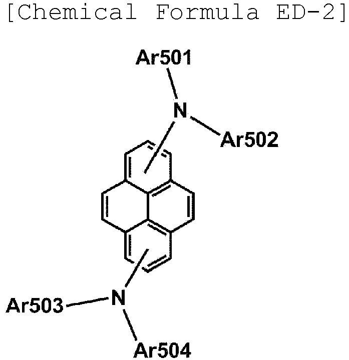

In Chemical Formula ED-2,
Ar501 to Ar504 are the same as those defined in Chemical Formula ED-1.

In an exemplary embodiment of the present specification, Ar501 to Ar504 are the same as or different from each other, and are each independently a substituted or unsubstituted aryl group.

In an exemplary embodiment of the present specification, Ar501 to Ar504 are the same as or different from each other, and are each independently a substituted or unsubstituted phenyl group; a substituted or unsubstituted biphenyl group; a substituted or unsubstituted terphenyl group; or a substituted or unsubstituted naphthyl group.

In an exemplary embodiment of the present specification, Ar501 to Ar504 are the same as or different from each other, and are each independently a phenyl group which is unsubstituted or substituted with a silyl group; a biphenyl group which is unsubstituted or substituted with a silyl group; a terphenyl group which is unsubstituted or substituted with a silyl group; or a naphthyl group which is unsubstituted or substituted with a silyl group.

In an exemplary embodiment of the present specification, Ar501 to Ar504 are the same as or different from each other, and are each independently a phenyl group which is unsubstituted or substituted with a silyl group.

In the present specification, the silyl group is a group represented by -SiRcRdRe, and Rc, Rd and Re are the same as or different from each other, and are each independently hydrogen; deuterium; a substituted or unsubstituted alkyl group; a substituted or unsubstituted aryl group; or a substituted or unsubstituted heteroaryl group. The number of carbon atoms of the silyl group is not particularly limited, but is preferably 1 to 60.

In an exemplary embodiment of the present specification, Chemical Formula ED-1 is the following structure.

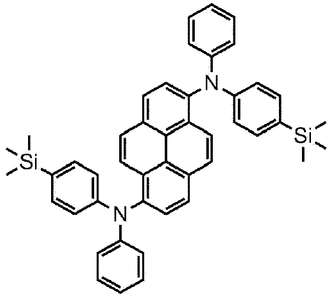

The hole injection layer is a layer which accepts holes. It is preferred that hole injection material has an ability to transport holes, and has an effect of accepting holes from an anode and an excellent hole injection effect for a light emitting layer or a light emitting material. Further, the hole injection material is preferably a material which is excellent in ability to prevent excitons produced from a light emitting layer from moving to an electron injection layer or an electron injection material and ability to form a thin film. In addition, the HOMO of the hole injection material is preferably a value between the work function of the anode material and the HOMO of the neighboring organic material layer. Specific examples of the hole injection material include: metal porphyrin, oligothiophene, and arylamine-based organic materials; hexanitrile hexaazatriphenylene-based organic materials; quinacridone-based organic materials; perylene-based organic materials; polythiophene-based conductive polymers such as anthraquinone and polyaniline; and the like, but are not limited thereto. Specifically, the hole injection material is an arylamine-based organic material.

In an exemplary embodiment of the present specification, the hole injection layer includes a compound of the following Chemical Formula HI-1.

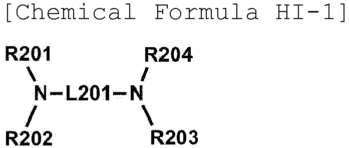

In Chemical Formula HI-1,
L201 is a substituted or unsubstituted arylene group, and
R201 to R204 are the same as or different from each other, and are each independently hydrogen; deuterium; a substituted or unsubstituted alkyl group; a substituted or unsubstituted cycloalkyl group; a substituted or unsubstituted aryl group; a substituted or unsubstituted heteroaryl group; a photocurable group or a thermosetting group.

In an exemplary embodiment of the present specification, L201 is a substituted or unsubstituted arylene group having 6 to 30 carbon atoms.

In an exemplary embodiment of the present specification, L201 is an arylene group.

In an exemplary embodiment of the present specification, L201 is a substituted or unsubstituted phenylene group; a substituted or unsubstituted biphenylene group; or a substituted or unsubstituted naphthylene group.

In an exemplary embodiment of the present specification, L201 is a phenylene group; a biphenylene group; or a naphthylene group.

In an exemplary embodiment of the present specification, L201 is a biphenylene group.

In an exemplary embodiment of the present specification, R201 to R204 are the same as or different from each other, and are each independently hydrogen; deuterium; a substituted or unsubstituted alkyl group having 1 to 30 carbon atoms; a substituted or unsubstituted cycloalkyl group having 3 to 30 carbon atoms; a substituted or unsubstituted aryl group having 6 to 30 carbon atoms; a substituted or unsubstituted heteroaryl group having 2 to 30 carbon atoms; a photocurable group or a thermosetting group.

In an exemplary embodiment of the present specification, R201 to R204 are the same as or different from each other, and are each independently a substituted or unsubstituted aryl group having 6 to 30 carbon atoms; a photocurable group or a thermosetting group.

In an exemplary embodiment of the present specification, R201 to R204 are the same as or different from each other, and are each independently an aryl group; a photocurable group or a thermosetting group.

In an exemplary embodiment of the present specification, R201 to R204 are the same as or different from each other, and are each independently a substituted or unsubstituted phenyl group; a substituted or unsubstituted biphenyl group; or a substituted or unsubstituted naphthyl group; a photocurable group or a thermosetting group.

In an exemplary embodiment of the present specification, R201 to R204 are the same as or different from each other, and are each independently a phenyl group; a biphenyl group; a naphthyl group; a photocurable group or a thermosetting group.

In the present specification, the photocurable group or thermosetting group may mean a reactive substituent which cross-links compounds or polymers by exposure to light and/or heat. The photocurable group or thermosetting group may be produced while radicals produced by decomposing carbon-carbon multiple bonds or cyclic structures by means of light irradiation or heat treatment are linked to each other.

In an exemplary embodiment of the present specification, the photocurable group or the thermosetting group is any one of the following structures.

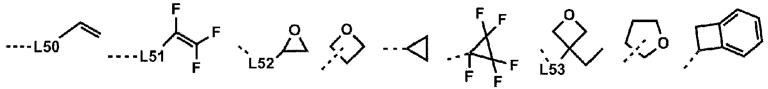

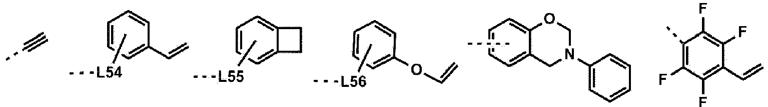

In the structures,
L50 to L56 are the same as or different from each other, and are each independently a direct bond; -O-; a substituted or unsubstituted alkylene group; or a substituted or unsubstituted arylene group, and
------ is a moiety bonded to Chemical Formula HI-1.

In an exemplary embodiment of the present specification, the photocurable group or the thermosetting group is any one of the following structures.

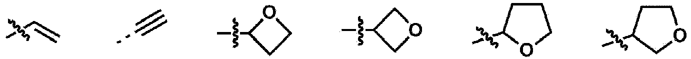

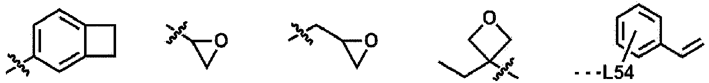

In the structures, L54 is a direct bond; or -O-, and ------ is a moiety bonded to Chemical Formula HT-1.

In an exemplary embodiment of the present specification, the photocurable group or thermosetting group is 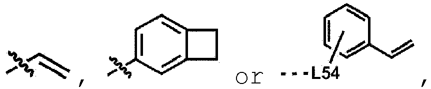 and L54 is a direct bond; or -O-.

In an exemplary embodiment of the present specification, the photocurable group or the thermosetting group is any one of the following structures.

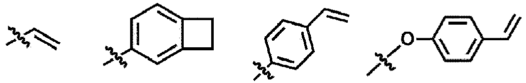

In an exemplary embodiment of the present specification, Chemical Formula HI-1 is the following structure.

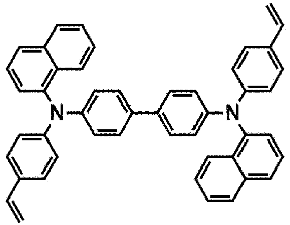

In an exemplary embodiment of the present specification, the hole injection layer further includes a p-doping material.

In the present specification, the p-doping material means a material which allows a host material to have p-semiconductor characteristics. The p-semiconductor characteristics mean characteristics of receiving or transporting holes at the highest occupied molecular orbital (HOMO) energy level, that is, characteristics of a material having large hole conductivity.

In an exemplary embodiment of the present specification, the p-doping material may be represented by any one of the following structures, but is not limited thereto.

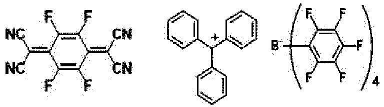

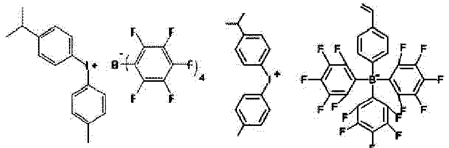

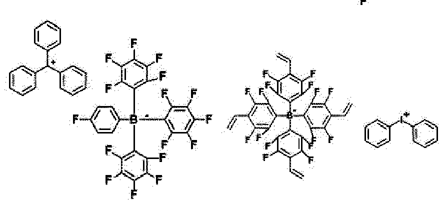

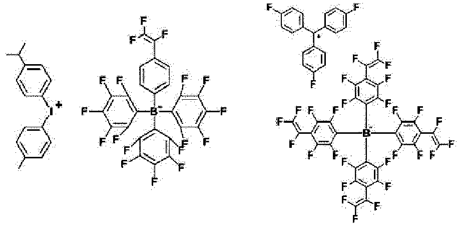

In the present specification, the p-doping material is sufficient as long as the material is a material which allows a host material to have p-semiconductor characteristics, one or two or more thereof may be used, and the type thereof is not limited.

In an exemplary embodiment of the present specification, the content of the p-doping material is 0 wt% to 500 wt% based on the compound of Chemical Formula HI-1. Specifically, the content of the p-doping material is 100 wt% to 400 wt% based on the compound of Chemical Formula HI-1.

In an exemplary embodiment of the present specification, the p-doping material is included in an amount of 0 to 50 wt% based on the solid content of the coating composition for forming a hole injection layer. In an exemplary embodiment of the present specification, it is preferred that the p-doping material is included in an amount of 1 to 50 wt% based on the total solid content of the composition, and it is more preferred that the p-doping material is included in an amount of 10 to 30 wt% based on the total solid content of the composition.

The hole transport layer is a layer which accepts holes from a hole injection layer and transports the holes to a light emitting layer, and may have a single-layered structure or a multi-layered structure having two or more layers. A hole transport material is preferably a material having high hole mobility which may accept holes from an anode or a hole injection layer and transfer the holes to a light emitting layer.

In an exemplary embodiment of the present specification, the hole transport layer includes a polymer including the unit of following Chemical Formula HT-1.

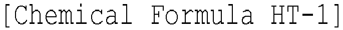

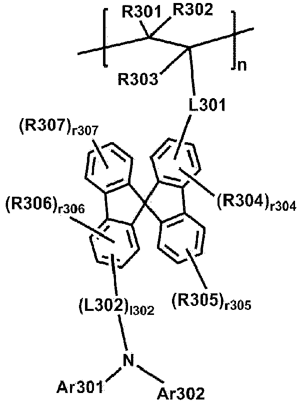

In Chemical Formula HT-1,
L301 and L302 are the same as or different from each other, and are each independently a direct bond; a substituted or unsubstituted arylene group; or a substituted or unsubstituted heteroarylene group,
l302 is an integer from 0 to 3, and when l302 is 2 or higher, L302's are the same as or different from each other,
Ar301 and Ar302 are the same as or different from each other, and are each independently a substituted or unsubstituted aryl group; or a substituted or unsubstituted heteroaryl group,
R301 to R307 are the same as or different from each other, and are each independently hydrogen; deuterium; a halogen group; a hydroxyl group; a cyano group; a substituted or unsubstituted alkyl group; a substituted or unsubstituted cycloalkyl group; a substituted or unsubstituted alkoxy group; a substituted or unsubstituted aryl group; or a substituted or unsubstituted heteroaryl group,
r304 and r306 are the same as or different from each other, and are each independently an integer from 0 to 3, r305 and r307 are the same as or different from each other, and are each independently an integer from 0 to 4, and when r304 to r307 are each 2 or higher, structures in the parenthesis are the same as or different from each other, and
n is a repeating number of the unit, and an integer from 2 to 10,000.

In an exemplary embodiment of the present specification, L301 and L302 are the same as or different from each other, and are each independently a direct bond; a substituted or unsubstituted arylene group.

In an exemplary embodiment of the present specification, L301 and L302 are the same as or different from each other, and are each independently a substituted or unsubstituted arylene group.

In an exemplary embodiment of the present specification, L301 and L302 are the same as or different from each other, and are each independently a substituted or unsubstituted phenylene group; a substituted or unsubstituted biphenylene group; or a substituted or unsubstituted naphthylene group.

In an exemplary embodiment of the present specification, L301 and L302 are the same as or different from each other, and are each independently a phenylene group; a biphenylene group; or a naphthylene group.

In an exemplary embodiment of the present specification, L301 and L302 are each a phenylene group.

In an exemplary embodiment of the present specification, R301 to R307 are the same as or different from each other, and are each independently hydrogen; deuterium; a substituted or unsubstituted alkyl group; or a substituted or unsubstituted aryl group.

In an exemplary embodiment of the present specification, R301 to R307 are the same as or different from each other, and are each independently hydrogen or deuterium.

In an exemplary embodiment of the present specification, Ar301 and Ar302 are the same as or different from each other, and are each independently a substituted or unsubstituted aryl group.

In an exemplary embodiment of the present specification, Ar301 and Ar302 are the same as or different from each other, and are each independently a substituted or unsubstituted phenyl group; a substituted or unsubstituted biphenyl group; a substituted or unsubstituted terphenyl group; a substituted or unsubstituted naphthyl group; or a substituted or unsubstituted fluorenyl group.

In an exemplary embodiment of the present specification, Chemical Formula HT-1 is the following structure.

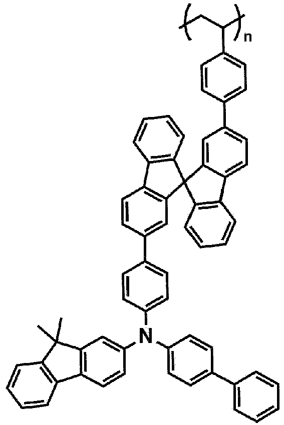

The electron transport layer is a layer which accepts electrons and transports the electrons to a light emitting layer. An electron transport material is preferably a material having high electron mobility which may proficiently accept electrons from a cathode and transfer the electrons to a light emitting layer. Specific examples thereof include: Al complexes of 8-hydroxyquinoline; complexes including Alq₃; organic radical compounds; hydroxyflavone-metal complexes; and the like, but are not limited thereto. The electron transport layer may be used with any desired cathode material, as used according to the related art. In particular, an appropriate cathode material is a typical material which has a low work function, followed by an aluminum layer or a silver layer. Specific examples thereof include cesium, barium, calcium, ytterbium, and samarium, in each case followed by an aluminum layer or a silver layer. In an exemplary embodiment of the present specification, the electron transport material is the above-described compound of Chemical Formula 1.

The electron injection layer is a layer which accepts electrons from an electrode. It is preferred that an electron injection material is excellent in ability to transport electrons and has an effect of accepting electrons from the cathode and an excellent electron injection effect for a light emitting layer or a light emitting material. Further, the electron injection material is preferably a material which prevents excitons produced from a light emitting layer from moving to a hole injection layer and is excellent in ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, metal complex compounds, nitrogen-containing 5-membered ring derivatives, and the like, but are not limited thereto. Examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, bis(2-methyl-8-quinolinato) (2-naphtholato) gallium, and the like, but are not limited thereto. In an exemplary embodiment of the present specification, the electron injection material is the above-described compound of Chemical Formula 1.

In an exemplary embodiment of the present specification, at least one of the electron injection layer, the electron transport layer, and the electron injection and transport layer includes the above-described compound.

The electron blocking layer is a layer which may improve the service life or efficiency of a device by preventing electrons injected from an electron injection layer from passing through a light emitting layer and entering a hole injection layer. A publicly-known electron blocking material may be used as the electron blocking material.

The hole blocking layer is a layer which blocks holes from reaching a cathode, and may be generally formed under the same conditions as those of the electron injection layer. Specific examples of the hole blocking layer material include oxadiazole derivatives or triazole derivatives, phenanthroline derivatives, aluminum complexes, and the like, but are not limited thereto.

The hole injection and transport layer may include materials for the above-described hole injection layer and hole transport layer.

The electron injection and transport layer may include materials for the above-described electron injection layer and electron transport layer.

When the organic light emitting device includes a plurality of organic material layers, the organic material layers may be formed of the same material or different materials.

The organic light emitting device according to the present invention may be a top emission type, a bottom emission type, or a dual emission type according to the material to be used.

An exemplary embodiment of the present invention provides an electronic device including an organic light emitting device including the above-described compound of Chemical Formula 1, a coating composition including the same, or a cured product thereof, or including an organic material layer formed using the coating composition.

The electronic device may include all of the interlayer insulation film of a semiconductor device, a color filter, a black matrix, an overcoat, a column spacer, a passivation film, a buffer coating film, a multilayer printed board insulation film, a cover coat of a flexible copper-clad board, a buffer coating film, a multilayer printed board insulation film, a solder resist film, an insulation film of an OLED, a protection film of a thin-film transistor of a liquid crystal display device, an electrode protection film and a semiconductor protection film of an organic EL device, an OLED insulation film, an LCD insulation film, a semiconductor insulation film, a solar light module, a touch panel, a display device such as a display panel, and the like, but is not limited thereto.

### [Mode for Invention]

Hereinafter, the present invention will be described in detail with reference to Examples for specifically describing the present invention. However, the Examples according to the present invention may be modified into various different forms, and it should not be interpreted that the scope of the present invention is limited to the Examples to be described below. The Examples of the present invention are provided for more completely describing the present invention to a person with ordinary skill in the art.

### <Synthesis Examples>

### Synthesis Example 1. Synthesis of Compound 1

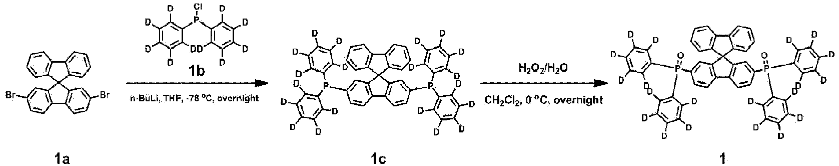

Compound 1a dried by oven drying was dissolved in anhydrous tetrahydrofuran (anhydrous THF) (0.1 M) and then substituted with a nitrogen atmosphere. After the temperature of the solution was lowered to -78°C, n-butyllithium (n-BuLi) (3.0 equiv. or more) was added dropwise, the resulting mixture was stirred for 30 minutes, and then Compound 1b (2.1 equiv.) was added dropwise thereto. After stirring overnight, the temperature of the solution was lowered to 0°C, and ethanol (EtOH) was added dropwise to terminate the reaction. After the aqueous layer was separated, a crude was obtained by EtOAc/H₂O extraction and purified by EtOAc column to obtain Compound 1c as a white solid. After the resulting Compound 1c was dissolved in CH₂Cl₂, the temperature of the solution was lowered to 0°C and excess H₂O₂ was slowly added dropwise thereto. Thereafter, after the substitution was confirmed by thin-layer chromatography (TLC), water was added dropwise to terminate the reaction. Thereafter, the CH₂Cl₂ layer was separated and purified by EtOAc column to obtain Compound 1.
MS: [M+H]⁺ = 736.8

### Synthesis Example 2. Synthesis of Compound 2

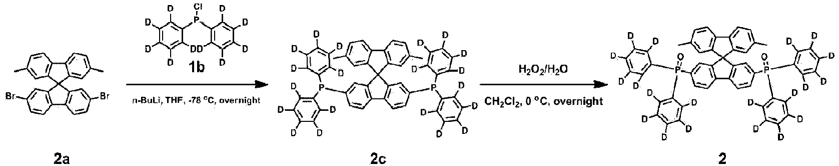

Compound 2 was prepared by the same preparation method as in Synthesis Example 1, except that Compound 2a was used instead of Compound 1a in Synthesis Example 1.
MS: [M+H]⁺ = 764.9

### Synthesis Example 3. Synthesis of Compound 3

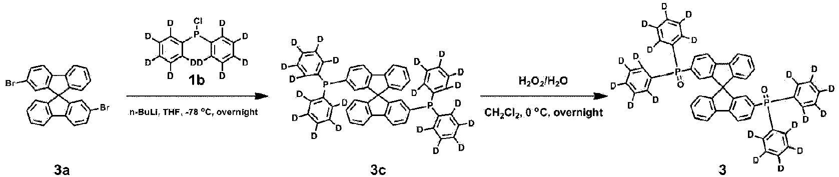

Compound 3 was prepared by the same preparation method as in Synthesis Example 1, except that Compound 3a was used instead of Compound 1a in Synthesis Example 1.
MS: [M+H]⁺ = 736.8

### Synthesis Example 4. Synthesis of Compound 4

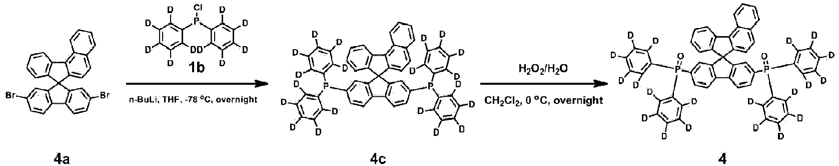

Compound 4 was prepared by the same preparation method as in Synthesis Example 1, except that Compound 4a was used instead of Compound 1a in Synthesis Example 1.
MS: [M+H]⁺ = 786.9

### Synthesis Example 5. Synthesis of Compound 5

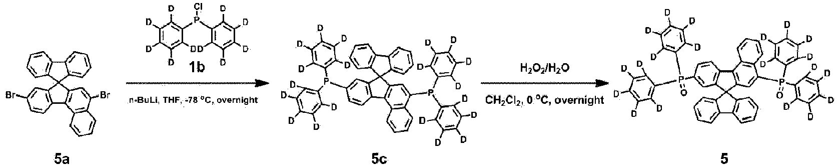

Compound 5 was prepared in the same manner as the preparation method of Synthesis Example 1, except that Compound 5a was used instead of Compound 1a in Synthesis Example 1. MS: [M+H]⁺ = 786.9

### Synthesis Example 6. Synthesis of Compound 6

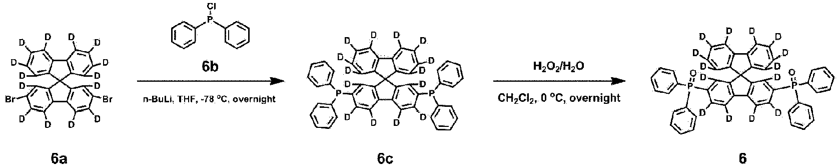

Compound 6 was prepared in the same manner as the preparation method of Synthesis Example 1, except that Compound 6a and Compound 6b were used instead of Compound 1a and Compound 1b, respectively, in Synthesis Example 1.
MS: [M+H]⁺ = 730.8

### Synthesis Example 7. Synthesis of Compound 7

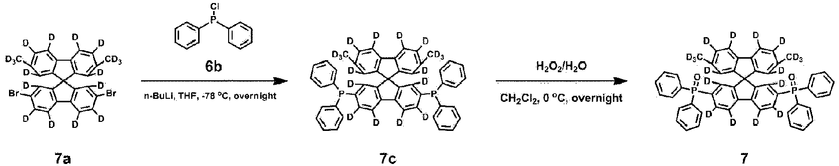

Compound 7 was prepared in the same manner as the preparation method of Synthesis Example 6, except that Compound 7a was used instead of Compound 6a in Synthesis Example 6. MS: [M+H]⁺ = 762.9

### Synthesis Example 8. Synthesis of Compound 8

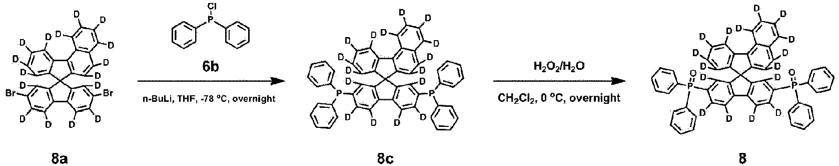

Compound 8 was prepared in the same manner as the preparation method of Synthesis Example 6, except that Compound 8a was used instead of Compound 6a in Synthesis Example 6. MS: [M+H]⁺ = 782.9

### Synthesis Example 9. Synthesis of Compound 9

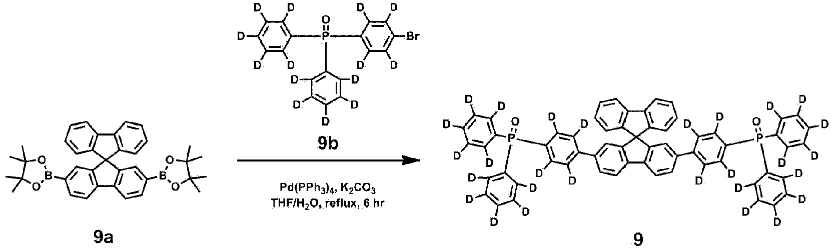

After Compound 9a, Compound 9b (2.3 equiv.), potassium carbonate (K₂CO₃) (3.0 equiv.) and tetrakis(triphenylphosphine)palladium(0) (Pd(PPh₃)₄) (0.05 equiv.) were dissolved in THF/H₂O (0.2 M), the resulting solution was warmed to 80°C and stirred for 6 hours. After the termination of the reaction was confirmed by TLC, a solid crude was obtained by EtOAC/H₂O extraction, and then subjected to column purification to obtain Compound 9.
MS: [M+H]⁺= 897.1

### Synthesis Example 10. Synthesis of Compound 10

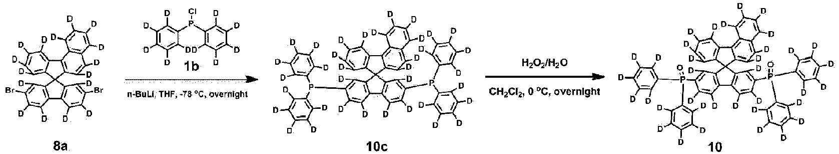

Compound 10 was prepared in the same manner as the preparation method of Synthesis Example 1, except that Compound 8a was used instead of Compound 1a in Synthesis Example 1. MS: [M+H]+ = 803.0

### Synthesis Example 11. Synthesis of Compound 11

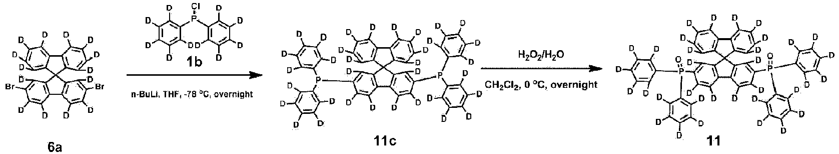

Compound 11 was prepared in the same manner as the preparation method of Synthesis Example 1, except that Compound 6a was used instead of Compound 1a in Synthesis Example 1. MS: [M+H]⁺= 750.9

### <Device Example>

### Example 1

A glass substrate thinly coated with indium tin oxide (ITO) to have a thickness of 500 Å was put into distilled water in which a detergent was dissolved, and ultrasonically washed. In this case, a product manufactured by the Fischer Co., was used as the detergent, and distilled water twice filtered using a filter manufactured by Millipore Co., was used as the distilled water. After the ITO was washed for 30 minutes, ultrasonic washing was conducted twice repeatedly using distilled water for 10 minutes. After the washing with distilled water was completed, the substrate was ultrasonically washed with a solvent of isopropyl and acetone, and dried, and then the substrate was cleaned for 5 minutes, and the substrate was transported to a glovebox.

The ITO transparent electrode was spin-coated (2500 rpm) with a coating composition in which the following compound p-dopant and the following compound HIL at a weight ratio of 2:8 were dissolved in cyclohexanone at 5 wt/v%, heat treatment (curing) was performed at 230°C for 30 minutes to form a hole injection layer having a thickness of 1000 Å.

The hole injection layer was spin-coated (2500 rpm) with a coating solution in which the following compound HTL (Mn: 27,900; Mw: 35,600; as measured by GPC using PC standard using Agilent 1200 series) was dissolved in toluene at 2 wt/v%, and heat treatment was performed at 230°C for 20 minutes to form a hole transport layer having a thickness of 1000 Å.

The hole transport layer was spin-coated (2000 rpm) with a coating composition in which the following compound A and the following compound Dopant at a weight ratio of 98:2 were dissolved in cyclohexanone at 2 wt/v%, and heat treatment was performed at 145°C for 15 minutes to form a light emitting layer having a thickness of 400 Å.

The light emitting layer was spin-coated (2000 rpm) with a coating solution in which Compound 1 prepared in Synthesis Example 1 and lithium quinolate (Liq) at a weight ratio of 3:7 were dissolved in a mixed solvent of ethylene glycol and 1-propanol (volume ratio of 8:2) at 2 wt/v%, and heat treatment was performed at 145°C for 10 minutes to form an electron injection and transport layer having a thickness of 300 Å.

Aluminum was deposited to have a thickness of 1000 Å on the electron injection and transport layer to form a cathode.

In the above process, the deposition rate of aluminum was maintained at 2° Å/sec, and the degree of vacuum during deposition was maintained at 5×10⁻⁸ torr to 2×10⁻⁷ torr.

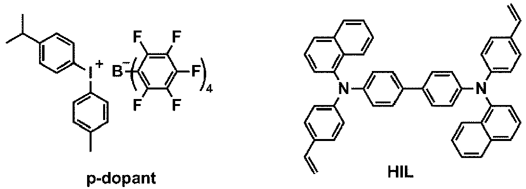

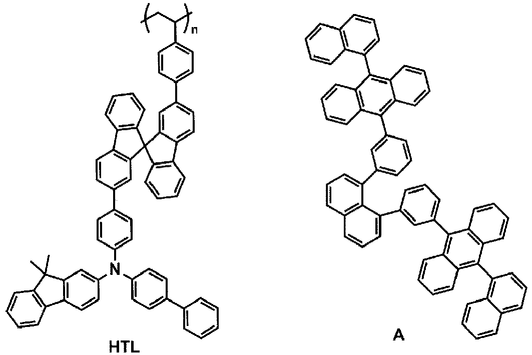

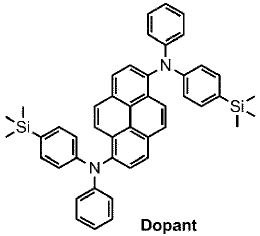

### Examples 2 to 11.

Organic light emitting devices were manufactured in the same manner as in Example 1, except that compounds described in the following Table 1 were used instead of Compound 1 during the preparation of the electron injection and transport layer in Example 1.

### Example 12.

A glass substrate thinly coated with indium tin oxide (ITO) to have a thickness of 500 Å was put into distilled water in which a detergent was dissolved, and ultrasonically washed. In this case, a product manufactured by the Fischer Co., was used as the detergent, and distilled water twice filtered using a filter manufactured by Millipore Co., was used as the distilled water. After the ITO was washed for 30 minutes, ultrasonic washing was conducted twice repeatedly using distilled water for 10 minutes. After the washing with distilled water was completed, the substrate was ultrasonically washed with a solvent of isopropyl and acetone, and dried, and then the substrate was cleaned for 5 minutes, and the substrate was transported to a glovebox.

The ITO transparent electrode was spin-coated (2500 rpm) with a coating composition in which the compound p-dopant and the compound HIL at a weight ratio of 2:8 were dissolved in cyclohexanone at 5 wt/v%, and heat treatment (curing) was performed at 230°C for 30 minutes to form a hole injection layer having a thickness of 1000 Å.

The hole injection layer was spin-coated (2500 rpm) with a coating composition in which the compound HTL was dissolved in toluene at 2 wt/v%, and heat treatment was performed at 230°C for 20 minutes to form a hole transport layer having a thickness of 1000 Å.

The hole transport layer was spin-coated (2000 rpm) with a coating composition in which the compound A and compound Dopant at a weight ratio of 98:2 were dissolved in cyclohexanone at 2 wt/v%, and heat treatment was performed at 145°C for 15 minutes to form a light emitting layer having a thickness of 400 Å.

Compound 1 prepared in Synthesis Example 1 and lithium quinolate (Liq) at a weight ratio of 3:7 were deposited on the light emitting layer to a thickness of 200 Å to form an electron injection and transport layer. In this case, the deposition rate was maintained at 1° Å/sec, and the degree of vacuum during deposition was maintained at 1×10⁻⁸ torr to 5×10⁻⁷ torr.

Aluminum was deposited to have a thickness of 1000 Å on the electron injection and transport layer to form a cathode. In this case, the deposition rate was maintained at 2° Å/sec, and the degree of vacuum during deposition was maintained at 5×10⁻⁸ torr to 2×10⁻⁷ torr.

### Examples 13 to 15

Organic light emitting devices were manufactured in the same manner as in Example 12, except that compounds described in the following Table 1 were used instead of Compound 1 during the preparation of the electron injection and transport layer in Example 12.

### Comparative Examples 1 and 2.

Organic light emitting devices were manufactured in the same manner as in Example 1, except that compounds described in the following Table 1 were used instead of Compound 1 during the preparation of the electron injection and transport layer in Example 1.

### Comparative Examples 3 and 4.

Organic light emitting devices were manufactured in the same manner as in Example 12, except that compounds described in the following Table 1 were used instead of Compound 1 during the preparation of the electron injection and transport layer in Example 12.

In the following Table 1, each of the structures of Compounds B to E is as follows.

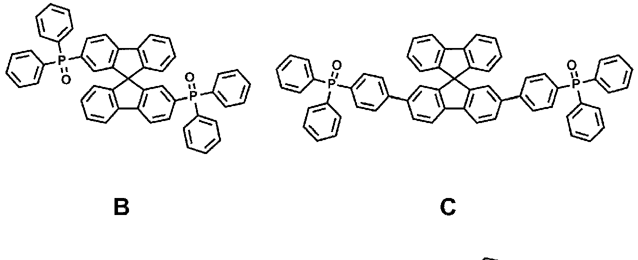

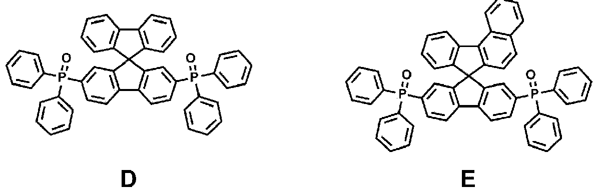

For the organic light emitting device manufactured in each of the Examples and Comparative Examples, the results of measuring the driving voltage, current efficiency, power efficiency, luminance and service life (T95) at a current density of 10 mA/cm² are shown in the following Table 1. T95 means the time (hr) taken for the luminance to be reduced to 95% of the initial luminance (500 nit).

**[Table 1]**

| | Compound | Driving voltage (V) | Current efficiency (Cd/A) | Power efficiency (lm/W) | Luminance (Cd/m2) | T95 (h) |
|---|---|---|---|---|---|---|
| Example 1 | Compound 1 | 4.63 | 5.08 | 3.45 | 507.68 | 111 |
| Example 2 | Compound 2 | 4.61 | 5.01 | 3.42 | 501.38 | 188 |
| Example 3 | Compound 3 | 4.74 | 4.93 | 3.26 | 492.72 | 137 |
| Example 4 | Compound 4 | 4.55 | 4.78 | 3.30 | 478.21 | 148 |
| Example 5 | Compound 5 | 4.42 | 4.78 | 3.40 | 477.67 | 180 |
| Example 6 | Compound 6 | 4.21 | 4.80 | 3.40 | 480.28 | 154 |
| Example 7 | Compound 7 | 4.66 | 5.10 | 3.82 | 498.01 | 133 |
| Example 8 | Compound 8 | 4.29 | 4.86 | 3.48 | 483.09 | 132 |
| Example 9 | Compound 9 | 4.97 | 4.67 | 3.28 | 480.67 | 164 |
| Example 10 | Compound 10 | 4.67 | 4.82 | 3.42 | 481.38 | 162 |
| Example 11 | Compound 11 | 4.51 | 4.91 | 3.60 | 493.65 | 124 |
| Example 12 | Compound 1 | 4.52 | 4.45 | 3.71 | 445.13 | 180 |
| Example 13 | Compound 3 | 4.64 | 4.62 | 3.44 | 438.05 | 150 |
| Example 14 | Compound 4 | 4.56 | 4.72 | 3.75 | 445.11 | 180 |
| Example 15 | Compound 6 | 4.29 | 4.28 | 3.48 | 441.46 | 160 |
| Comparative Example 1 | Compound B | 6.14 | 4.82 | 2.47 | 481.92 | 85 |
| Comparative Example 2 | Compound C | 5.61 | 3.97 | 2.22 | 396.55 | 67 |
| Comparative Example 3 | Compound D | 5.94 | 4.11 | 2.41 | 370.97 | 116 |
| Comparative Example 4 | Compound E | 5.67 | 4.24 | 2.35 | 320.86 | 124 |

As shown in Table 1, it could be confirmed that the organic light emitting devices (Examples 1 to 15) to which the compound of Chemical Formula 1 including deuterium according to the present specification was applied had low driving voltage and improved efficiency and service life compared to the organic light emitting devices (Comparative Examples 1 to 4) to which the compound including no deuterium was applied.

## Claims

1. A compound of the following Chemical Formula 1: 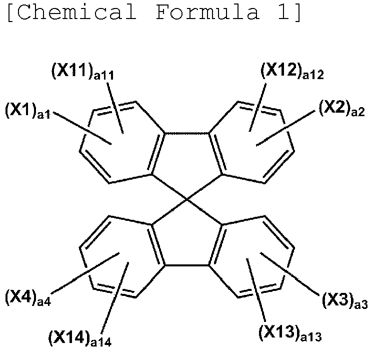
wherein, in Chemical Formula 1,
X1 to X4 are the same as or different from each other, and are each independently a group represented by the following Chemical Formula 2,
X11 to X14 are the same as or different from each other, and are each independently hydrogen; deuterium; a halogen group; a substituted or unsubstituted alkyl group; a substituted or unsubstituted cycloalkyl group; a substituted or unsubstituted aryl group; or a substituted or unsubstituted heteroaryl group, or are bonded to an adjacent group to form a substituted or unsubstituted ring,
a1 to a4 are each an integer of 0 or 1, and a1+a2+a3+a4 is an integer from 2 to 4,
a11 to a14 are each an integer from 0 to 4, and when a11 to a14 are each an integer of 2 or higher, substituents in the parenthesis are the same as or different from each other, 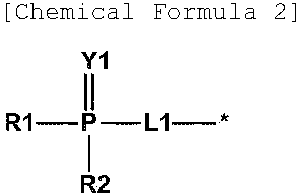 in Chemical Formula 2,
Y1 is O, S or Se,
L1 is a direct bond; a substituted or unsubstituted alkylene group; a substituted or unsubstituted arylene group; or a substituted or unsubstituted heteroarylene group,
R1 and R2 are the same as or different from each other, and are each independently hydrogen; deuterium; a halogen group; a substituted or unsubstituted alkyl group; a substituted or unsubstituted cycloalkyl group; a substituted or unsubstituted aryl group; or a substituted or unsubstituted heteroaryl group, and
at least one of X1 to X4 and X11 to X14 includes deuterium.

2. The compound of claim 1, wherein Chemical Formula 1 is the following Chemical Formula 1-1 or 1-2: 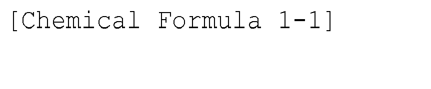 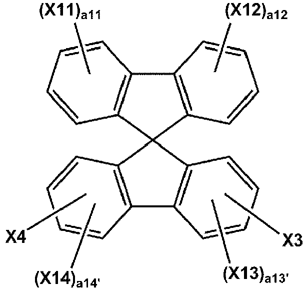 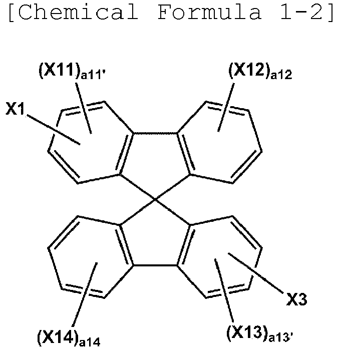 in Chemical Formulae 1-1 and 1-2,
X1, X3, X4, X11 to X14, a11, a12 and a14 are the same as those defined in Chemical Formula 1, and
a11', a13' and a14' are each an integer from 1 to 3, and when a11', a13' and a14' are each 2 or higher, substituents in the parenthesis are the same as or different from each other.

3. The compound of claim 1, wherein Chemical Formula 1 is any one of the following Chemical Formulae 1-4 to 1-6: 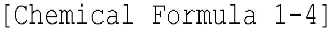 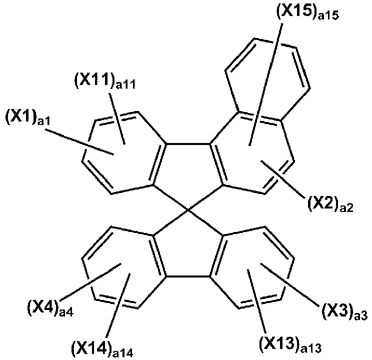 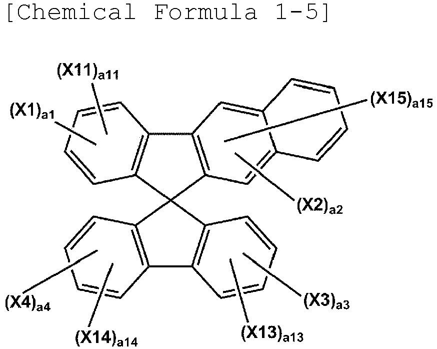 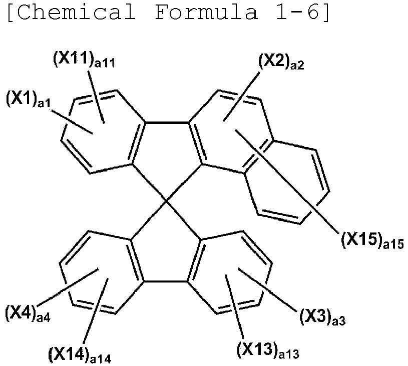 in Chemical Formulae 1-4 to 1-6,
X1 to X4, X11, X13, X14, a1 to a4, a11, a13 and a14 are the same as those defined in Chemical Formula 1,
X15 is hydrogen; deuterium; a halogen group; a substituted or unsubstituted alkyl group; a substituted or unsubstituted cycloalkyl group; a substituted or unsubstituted aryl group; or a substituted or unsubstituted heteroaryl group,
at least one of X1 to X4, X11 and X13 to X15 includes deuterium, and
a15 is an integer from 1 to 6, and when a15 is an integer of 2 or higher, structures in the parenthesis are the same as or different from each other.

4. The compound of claim 1, wherein R1 and R2 are the same as or different from each other, and are each independently hydrogen; deuterium; or a substituted or unsubstituted aryl group.

5. The compound of claim 1, wherein X11 to X14 are the same as or different from each other, and are each independently hydrogen; deuterium; or a substituted or unsubstituted alkyl group, or are bonded to an adjacent substituent to form a substituted or unsubstituted ring.

6. The compound of claim 1, wherein a deuterium substitution rate of the compound of Chemical Formula 1 is 20% or more.

7. The compound of claim 1, wherein the compound of Chemical Formula 1 is any one of the following structures:

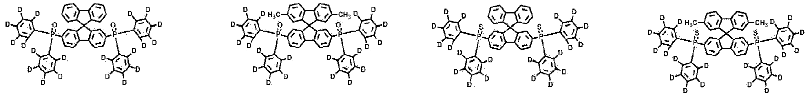

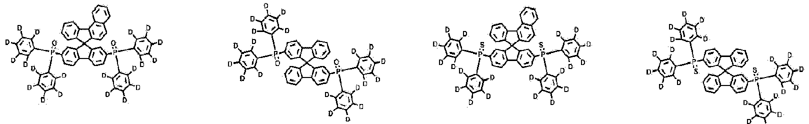

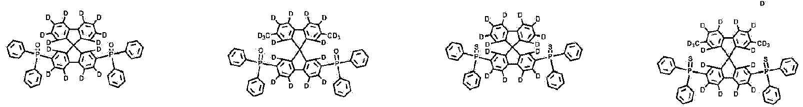

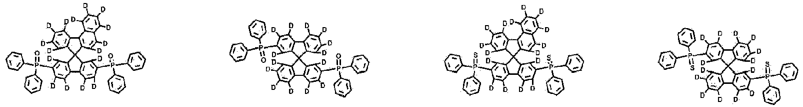

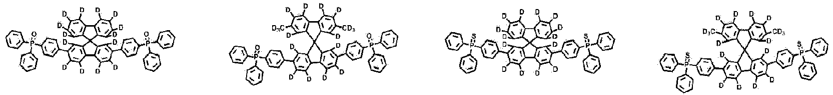

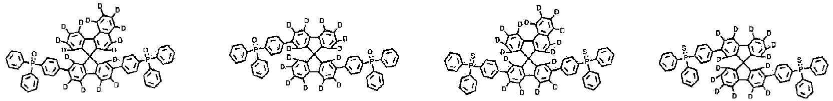

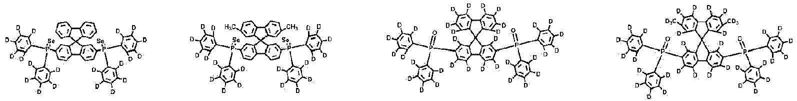

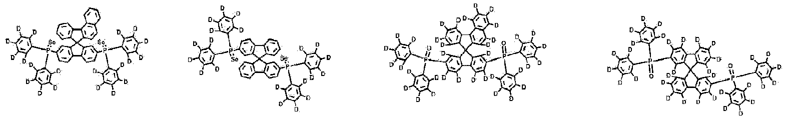

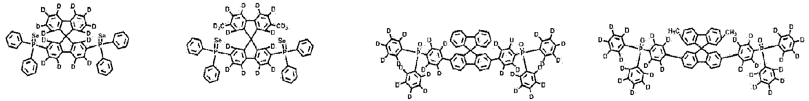

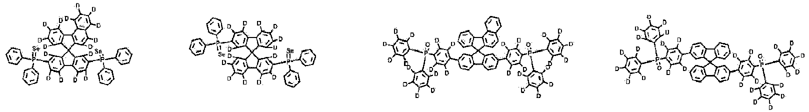

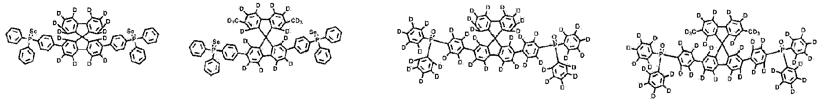

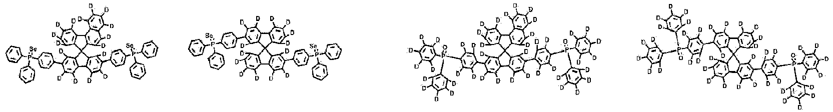

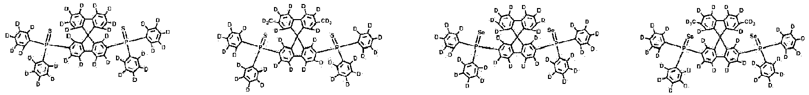

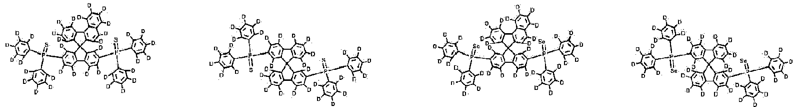

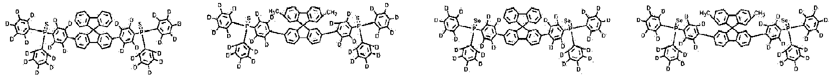

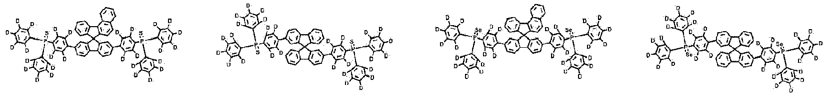

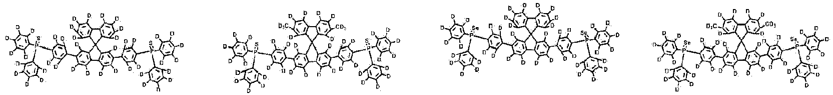

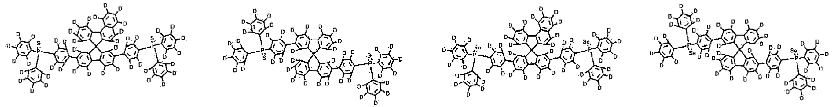

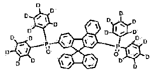

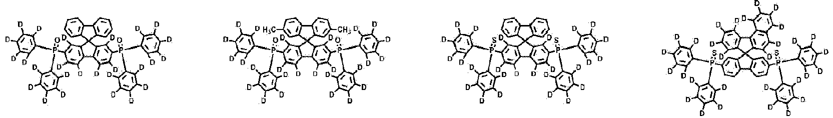

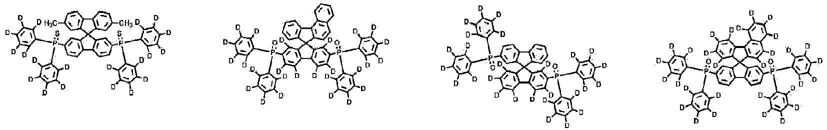

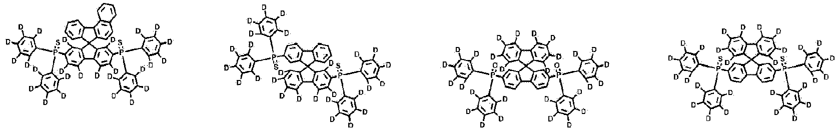

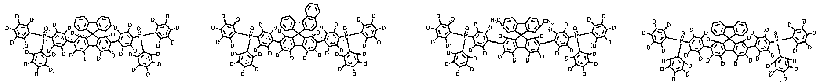

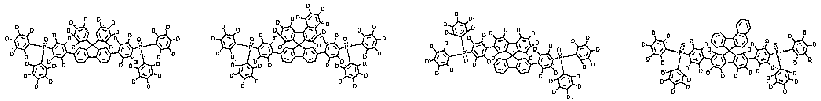

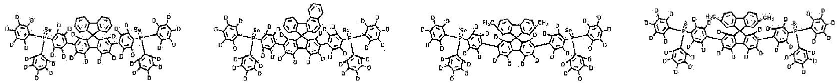

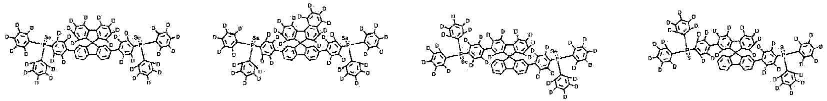

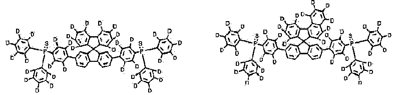

8. A coating composition comprising the compound of any one of claims 1 to 7.

9. An organic light emitting device comprising: a first electrode;
a second electrode; and
an organic material layer having one or more layers provided between the first electrode and the second electrode,
wherein one or more layers of the organic material layer comprise the coating composition of claim 8 or a cured product thereof.

10. The organic light emitting device of claim 9, wherein the organic material layer comprises a light emitting layer and a first organic material layer, and
the first organic material layer comprises the coating composition or a cured product thereof.

11. The organic light emitting device of claim 10, wherein the second electrode is a cathode, and
the first organic material layer is provided between the light emitting layer and the cathode.

12. The organic light emitting device of claim 10, wherein the first organic material layer is at least one of an electron injection layer; an electron transport layer; and an electron injection and transport layer.

13. A method for manufacturing an organic light emitting device, the method comprising: preparing a first electrode;
forming an organic material layer having one or more layers on the first electrode; and
forming a second electrode on the organic material layer,
wherein the forming of the organic material layer comprises forming an organic material layer having one or more layers by using the coating composition of claim 8.

14. The method of claim 13, wherein the forming of the organic material layer having one or more layers by using the coating composition comprises:
coating the coating composition on the first electrode; and
heat-treating or light-treating the coated coating composition.

15. A method for manufacturing an organic light emitting device, the method comprising: preparing a first electrode;
forming an organic material layer having one or more layers on the first electrode; and
forming a second electrode on the organic material layer,
wherein the forming of the organic material layer comprises forming an organic material layer having one or more layers by depositing the compound of any one of claims 1 to 7.
